(19) Europäisches Patentamt / European Patent Office / Office européen des brevets

(11) **EP 4 191 658 A1**

(12) **EUROPEAN PATENT APPLICATION**
published in accordance with Art. 153(4) EPC

(43) Date of publication:
**07.06.2023 Bulletin 2023/23**

(21) Application number: **21848982.1**

(22) Date of filing: **26.07.2021**

(51) International Patent Classification (IPC):
**H01L 23/02** (2006.01)   **H01L 23/28** (2006.01)
**H01L 23/29** (2006.01)   **H01L 23/31** (2006.01)
**H01L 27/146** (2006.01)   **H04N 5/335** (2011.01)

(52) Cooperative Patent Classification (CPC):
**H01L 23/02; H01L 23/28; H01L 23/29; H01L 23/31;
H01L 27/146; H04N 25/00**

(86) International application number:
**PCT/JP2021/027489**

(87) International publication number:
**WO 2022/024972 (03.02.2022 Gazette 2022/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **27.07.2020 JP 2020126759**

(71) Applicant: **Sony Semiconductor Solutions
Corporation
Atsugi-shi, Kanagawa 243-0014 (JP)**

(72) Inventors:
• **OTSUKA, Yasushi**
  **Atsugi-shi, Kanagawa 243-0014 (JP)**
• **DONG, Wenshuang**
  **Atsugi-shi, Kanagawa 243-0014 (JP)**
• **AOKI, Shumpei**
  **Atsugi-shi, Kanagawa 243-0014 (JP)**
• **KANATAKE, Mitsuhito**
  **Atsugi-shi, Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(54) **SOLID-STATE IMAGING DEVICE, METHOD FOR MANUFACTURING SOLID-STATE IMAGING DEVICE, AND ELECTRONIC APPARATUS**

(57) A solid-state imaging apparatus is provided that, in a configuration including a mold resin portion formed around an image sensor and cover glass, enables potential burrs of the mold resin on a cover glass surface to be prevented without the need for a dedicated mold, the cover glass having a light blocking effect, and a method for manufacturing the solid-state imaging apparatus and electronic equipment are also provided.

The solid-state imaging apparatus includes a substrate, an image sensor provided on the substrate, a transparent member provided on the image sensor via a support portion, and a mold resin portion formed around the image sensor and the transparent member on the substrate, and a front surface, a side surface, or a back surface of the transparent member is provided with a groove portion in a region outside a light receiving area of the image sensor. Furthermore, to eliminate the adverse effect of light reflected to an inner side surface of the groove portion, a V-shaped groove portion is formed, and the inner side surface of the V-shaped groove portion has an angle defined as half of a maximum refracting angle or larger.

FIG.2

EP 4 191 658 A1

**Description**

[Technical Field]

The present disclosure relates to a solid-state imaging apparatus, a method for manufacturing a solid-state imaging apparatus, and electronic equipment.

[Background Art]

The related art includes solid-state imaging apparatuses including CMOS (Complementary Metal Oxide Semiconductor) or CCD (Charge Coupled Device) image sensors as solid-state imaging elements, and some of these solid-state imaging apparatuses include the following package structure. Specifically, the package structure includes translucent cover glass mounted, via a support portion, on an image sensor mounted on a substrate, the support section including resin or the like, and a mold resin portion is formed around the image sensor and the cover glass on the substrate.

As a method for manufacturing a package structure for such an image sensor, a manufacturing method is known in which injection molding is performed using a mold tool to form a mold resin portion. Specifically, multiple image sensors are mounted on an integral substrate sheet corresponding to a substrate of the solid-state imaging apparatus and formed in an aggregation state, and glass is mounted on each of the image sensors via a support portion. The resultant configuration is set in a formation space for the mold tool. Then, the mold resin is injected into the formation space, and a mold resin portion is formed in conformance to the shape of the formation space. After the injection molding, the substrate sheet and the mold resin portion are cut and divided into areas corresponding to the image sensors, and the above-described package structure is obtained.

As a problem with the method for forming the mold resin portion by injection molding as described above, the mold resin infiltrates or permeates through a surface of the cover glass due to pressurized injection of the resin during the injection molding, leading to generation of resin burrs on the surface of the cover glass. The resin burrs including the mold resin are generated on the surface of the cover glass, and when the resin burrs are present in a light receiving area, light reception of the image sensor may be seriously affected. Thus, potential resin burrs on the cover glass need to be prevented.

Additionally, in the solid-state imaging apparatus, at the outer periphery of the light receiving area of the image sensor, a dam material is formed like a wall and is shaped like a rectangular frame all along the contour of the cover glass. The cover glass is mounted via the dam material.

However, in such a configuration, a portion of light incident on the cover glass is reflected by the dam material, and the reflected light may reach the light receiving area of the image sensor. Flare may be caused by the reflected light from the dam material reaching the light receiving area. Thus, the reflected light from the dam material needs to be prevented.

Thus, to prevent potential resin burrs on the cover glass, for example, a technique disclosed in PTL 1 may be used. PTL 1 discloses a technique for forming a resin sealing portion of an image sensor using a transfer mold tool. The transfer mold tool includes a lower mold disposed below the image sensor and an upper mold disposed above the image sensor. The upper mold includes a base material, a release film provided on the base material and on the image sensor side, and a protruding portion provided between the base material and the release film. The protruding portion is disposed corresponding to an outer peripheral portion of the cover glass in a plane direction of the image sensor.

In the configuration disclosed in PTL 1, the release film is pressed against the cover glass by the protruding portion, and thus in injection molding, infiltration or the like of the mold resin onto the cover glass may be suppressed, restricting generation of the resin burrs on the cover glass.

Additionally, various measures have been attempted to prevent flare caused by reflected light from the dam material but have not been established.

[Citation List]

[Patent Literature]

[PTL 1]
Japanese Patent Laid-open No. 2016-004856

[Summary]

[Technical Problems]

However, in the technique disclosed in PTL 1, the protruding portion is provided on the upper mold of the transfer mold tool, and thus the mold has a complicated structure, leading to problems such as high investment in molding and cumbersome setting of molding conditions. Additionally, the protruding portion is positioned on the upper mold and corresponds to the outer peripheral portion of the cover glass, leading to the need for a dedicated mold with a size matching the size of the cover glass. Thus, with each change in the size or position of the cover glass or each change in layout on the substrate, a dedicated mold needs to be prepared. This situation is difficult to address.

In view of the above-described problems, an object of the present disclosure is to provide a solid-state imaging apparatus that, in a configuration including a mold resin portion formed around an image sensor and cover glass, enables potential burrs of the mold resin on the cover glass surface to be prevented without the need for a dedicated mold, the cover glass producing a light blocking effect, and to also provide a method for manufacturing a solid-state imaging apparatus and electronic equipment.

[Solution to Problems]

The present disclosure is intended to solve the above-described problems, and a first aspect of the present disclosure is a solid-state imaging apparatus including a substrate, an image sensor provided on the substrate, a transparent member provided on the image sensor via a support portion, and a mold resin portion formed around the image sensor and the transparent member on the substrate, in which a front surface side of the transparent member is provided with a groove portion in a region outside a light receiving area of the image sensor.

A second aspect of the present disclosure is a solid-state imaging apparatus including a substrate, an image sensor provided on the substrate, a transparent member provided on the image sensor via a support portion, and a mold resin portion formed around the image sensor and the transparent member on the substrate, in which a side surface of the transparent member is provided with a groove portion in a region outside a light receiving area of the image sensor.

A third aspect of the present disclosure is a solid-state imaging apparatus including a substrate, an image sensor provided on the substrate, a transparent member provided on the image sensor via a support portion, and a mold resin portion formed around the image sensor and the transparent member on the substrate, in which a back surface of the transparent member is provided with a groove portion in a region outside a light receiving area of the image sensor.

Additionally, in the first or second aspect, the mold resin portion may include a material having a light blocking effect, and the groove portion may be internally filled with a material forming the mold resin portion.

In addition, in the first or second aspect, the transparent member may be a member shaped like a rectangular plate, and the groove portion may be formed along four sides of the transparent member.

Additionally, in the first aspect, the transparent member may include a plurality of the groove portions along at least one of the four sides of the transparent member.

In addition, in the first aspect, the groove portion may be shaped like a rectangle surrounding an outer periphery of the light receiving area.

Additionally, in the first or second aspect, a light blocking film may be formed on an inner surface of the groove portion.

In addition, in the second aspect, a corner portion between the front surface and the side surface of the transparent member may have an acute angle.

Additionally, in the third aspect, in the front surface and the back surface of the transparent member, the groove portion may be formed in a region outside the light receiving area of the image sensor.

In addition, in the third aspect, the groove portion formed in the back surface of the transparent member may be formed in such a manner that the support portion of the transparent member is fitted into the groove portion.

Additionally, in the third aspect, the groove portion formed in the back surface of the transparent member may be provided with a width larger than that of the support portion of the transparent member.

In addition, in the third aspect, the groove portion formed in the back surface of the transparent member may be provided with a rough surface on an inner peripheral surface of the groove portion.

A fourth aspect of the present disclosure is a solid-state imaging apparatus including a transparent member shaped like a rectangular plate and a groove portion that is formed in the front surface of the transparent member along four sides of the rectangular plate and that has a V shape or an inverted trapezoidal shape having an angle $\theta 3$ between an oblique side and a perpendicular, the angle being larger than half of a maximum refracting angle $\theta c1$.

Additionally, in the fourth aspect, the groove portion may be shaped like a rectangle surrounding an outer periphery of a light receiving area of an image sensor.

In addition, in the fourth aspect, the groove portion may be internally provided with a light blocking film or filled with a material having a light blocking effect.

A fifth aspect of the present disclosure is a method for manufacturing a solid-state imaging apparatus, the method including the steps of preparing, as a member covering a front surface side of an image sensor, a transparent member including a groove portion with at least one side opening to a side surface of the transparent member, in a region outside an area portion corresponding to a light receiving area of the image sensor on the front surface side, mounting multiple image sensors on a substrate sheet to produce a package substrate sheet with the transparent member provided on each of the image sensors via a support portion, performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side and injecting a resin material into the molding space to form a mold resin portion around the image sensor and the transparent member on the substrate sheet, and dividing a plate-like structure with the mold resin portion formed on the package substrate sheet into multiple chips corresponding to the image sensors.

A sixth aspect of the present disclosure is a method for manufacturing a solid-state imaging apparatus, the method including the steps of preparing, as a member covering a front surface side of an image sensor, a transparent member including a groove portion opening to a side surface of the transparent member, in a region outside an area portion corresponding to a light receiving area of the image sensor on the front surface side, mounting multiple image sensors on a substrate sheet to produce a package substrate sheet with the transparent member provided on each of the image sensors via a support portion, performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side and injecting a resin material into the molding space to form a mold resin portion around the image sensor and the transparent member on the substrate sheet, and dividing a plate-like structure with the mold resin portion formed on the package substrate sheet into multiple chips corresponding to the image sensors.

A seventh aspect of the present disclosure is a method for manufacturing a solid-state imaging apparatus, the method including the steps of preparing, as a member covering a front surface side of an image sensor, a transparent member including a groove portion formed in such a manner that a support portion is fitted, in a region outside an area portion corresponding to a light receiving area of the image sensor on a back surface side, the support portion being disposed in the region, mounting multiple image sensors on a substrate sheet to produce a package substrate sheet with the transparent member provided on each of the image sensors via the support portion, performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side, and injecting a resin material into the molding space to form a mold resin portion around the image sensor and the transparent member on the substrate sheet, and dividing a plate-like structure with the mold resin portion formed on the package substrate sheet into multiple chips corresponding to the image sensors.

Additionally, in any of the fifth to seventh aspects, in the step of forming the mold resin portion, a material having a light blocking effect may be used as the resin material.

An eighth aspect of the present disclosure is electronic equipment including a solid-state imaging apparatus including a substrate, an image sensor provided on the substrate, a transparent member provided on the image sensor via a support portion, and a mold resin portion formed around the image sensor and the transparent member on the substrate, in which a front surface, a side surface, or a back surface of the transparent member is provided with a groove portion in a region outside a light receiving area of the image sensor.

A ninth aspect of the present disclosure is electronic equipment including a solid-state imaging apparatus including a transparent member formed like a rectangular plate, and a groove portion that is formed in a front surface of the transparent member along four sides of the rectangular plate and that has a V shape or an inverted trapezoidal shape having an angle $\Theta 3$ between an oblique side and a perpendicular, the angle being larger than half of a maximum refracting angle $\theta c1$.

In the above-described aspects, the upper mold presses the sheet covering the cover glass and an upper surface of the groove engraved in the front surface of the cover glass, and the portion of the sheet covering the groove bulges into the groove and penetrates into and comes into close contact with corner portions at peripheral edges of the groove and corner portions at peripheral edges of the cover glass. Thus, the mold resin can be inhibited from infiltrating or permeating through the junction surface between the cover glass and the sheet, allowing potential burrs of the mold resin on the front surface of the cover glass to be prevented.

Additionally, when the sheet closely contacts and covers the entire front surface of the cover glass and is filled with the mold resin material, the mold resin material flows into the groove engraved in the side surface of the cover glass, and forms a flow of the mold resin material. Consequently, the sheet is drawn by the mold resin flowing into the groove formed in the side surface of the cover glass and comes into close contact with the corner portions at the peripheral edges of the cover glass. Thus, the mold resin can be inhibited from infiltrating or permeating through the junction surface between the cover glass and the sheet, allowing potential burrs of the mold resin on the front surface of the cover glass to be prevented.

Additionally, injection molding causes the front surface of the cover glass or the groove engraved in the side surface of the cover glass to be filled with the mold resin. Consequently, with the use of black mold resin containing carbon, the groove can be formed as a black light blocking film. Furthermore, by varying the position or width of the groove formed in the cover glass, a light blocking area can be freely set.

According to the present disclosure, the mold resin can be injection-molded using a general-purpose mold tool including an upper mold and an inner mold both including a flat inner surface, enabling potential resin burrs on the front surface of the cover glass to be prevented. Thus, the present disclosure has an effect of providing a solid-state imaging apparatus including cover glass having a light blocking effect.

[Brief Description of Drawings]

[FIG. 1]

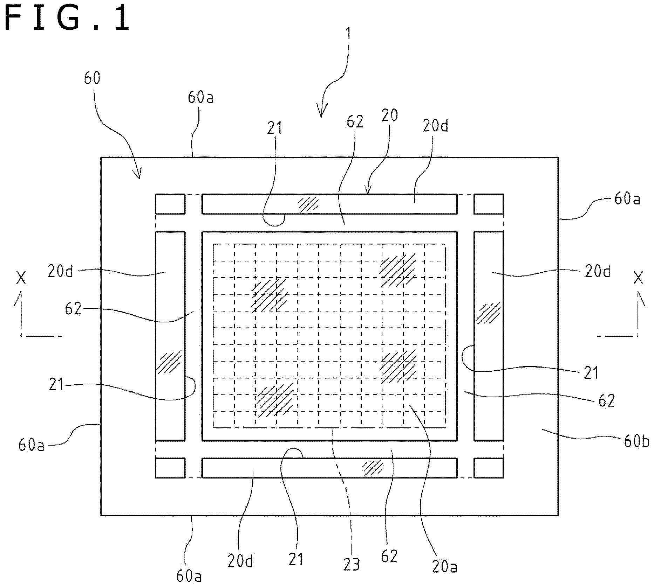

FIG. 1 is a plan view depicting a configuration example of a solid-state imaging apparatus according to a first embodiment of the present disclosure.
[FIG. 2]

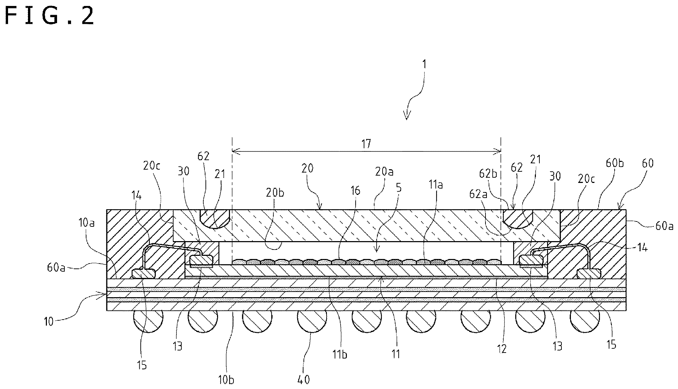

FIG. 2 is a cross-sectional view taken along line X-X in FIG. 1.
[FIG. 3]

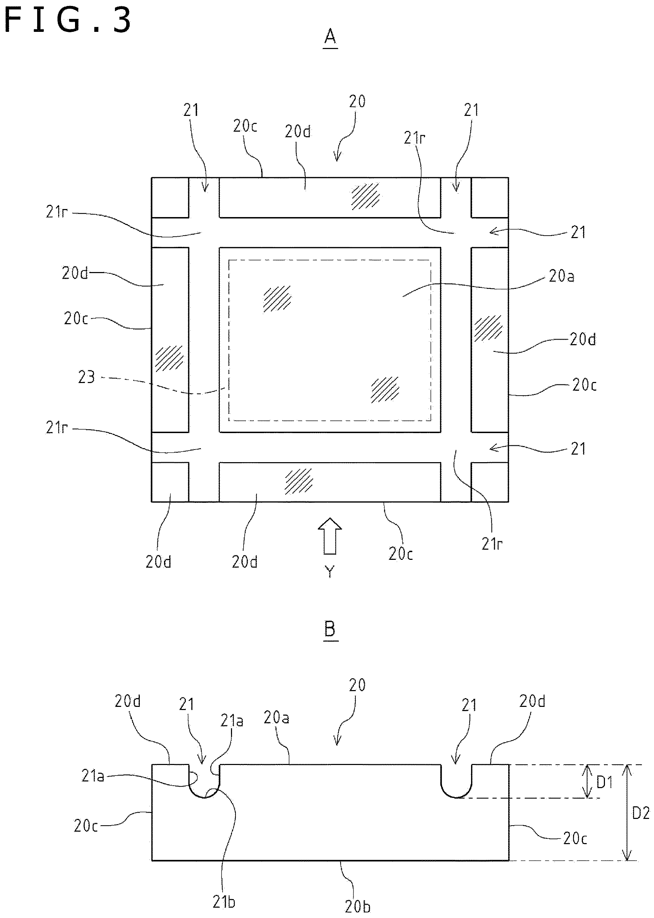

FIG. 3 depicts a plan view and a side view of cover glass used in the solid-state imaging apparatus according to the first embodiment of the present disclosure.
[FIG. 4]

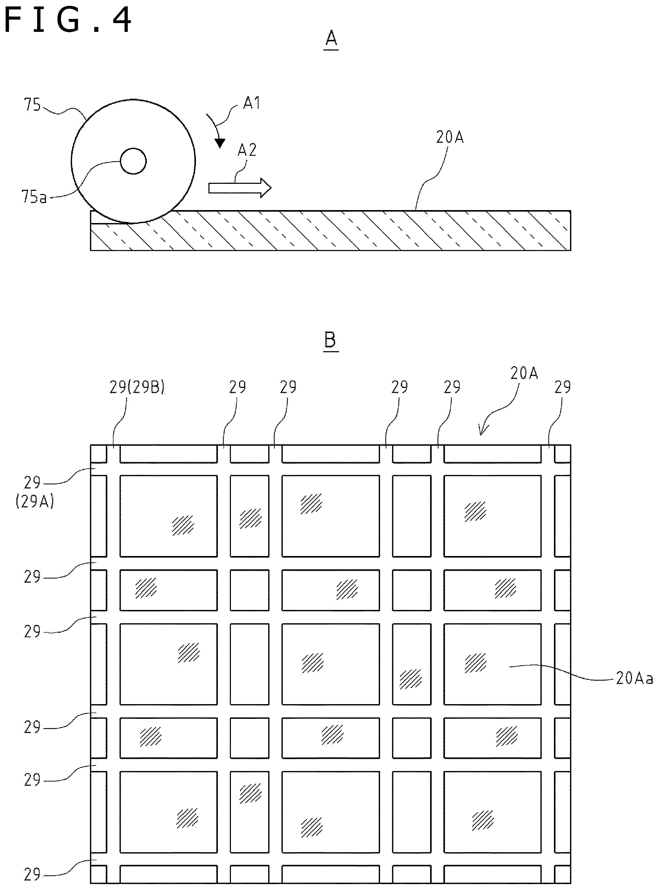

FIG. 4 is an explanatory diagram of the step of forming horizontal grooves in a glass panel in a method for manufacturing a solid-state imaging apparatus.
[FIG. 5]

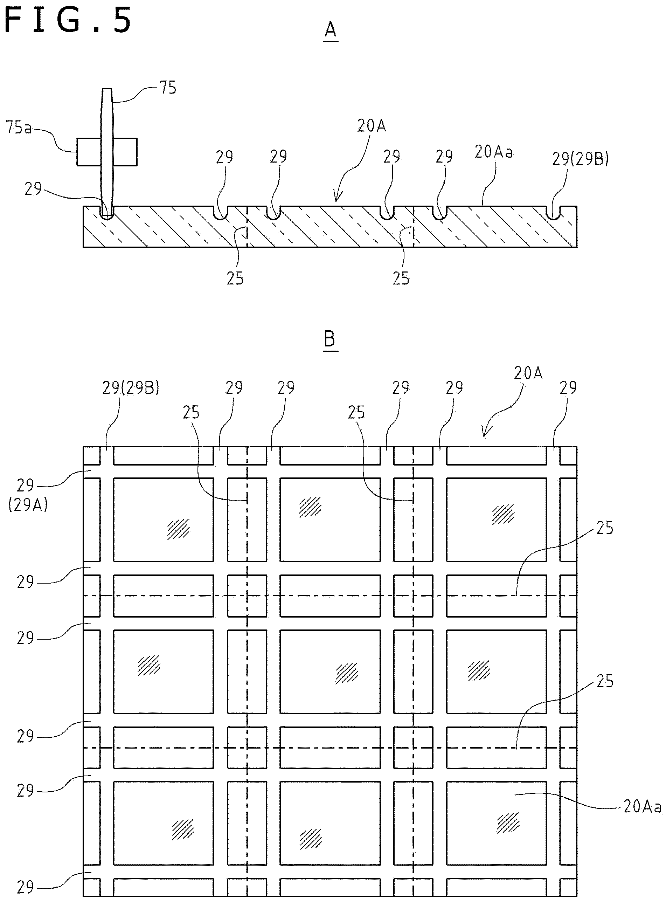

FIG. 5 is an explanatory diagram of the step of forming vertical grooves in the glass panel dividing the glass panel into pieces in the method for manufacturing a solid-state imaging apparatus.
[FIG. 6]

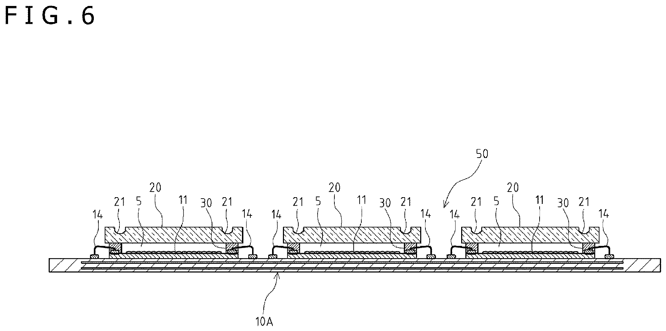

FIG. 6 is a side cross-sectional view of an organic substrate sheet assembled in the method for manufacturing a solid-state imaging apparatus.
[FIG. 7]

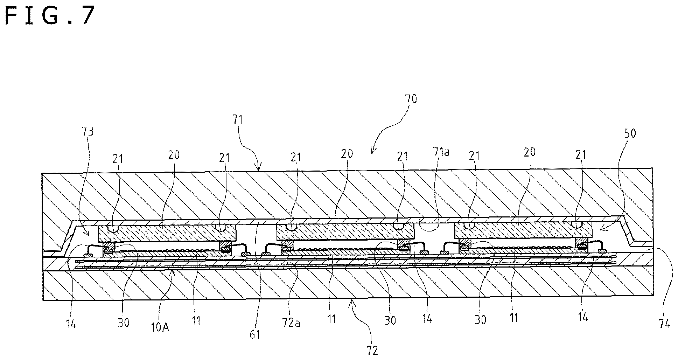

FIG. 7 is a cross-sectional view illustrating a mold closing step in the method for manufacturing a solid-state imaging apparatus.
[FIG. 8]

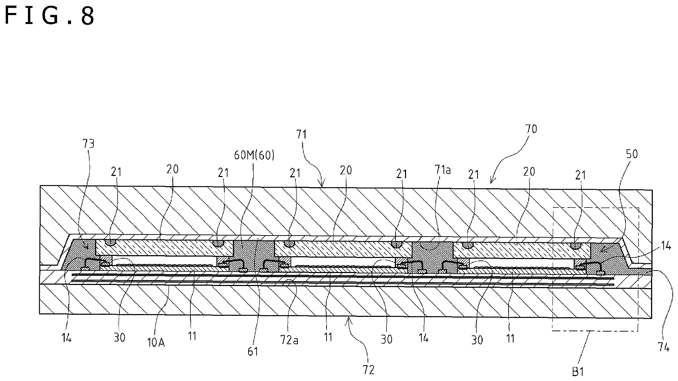

FIG. 8 is a cross-sectional view illustrating an injection step in the method for manufacturing a solid-state imaging apparatus.
[FIG. 9]

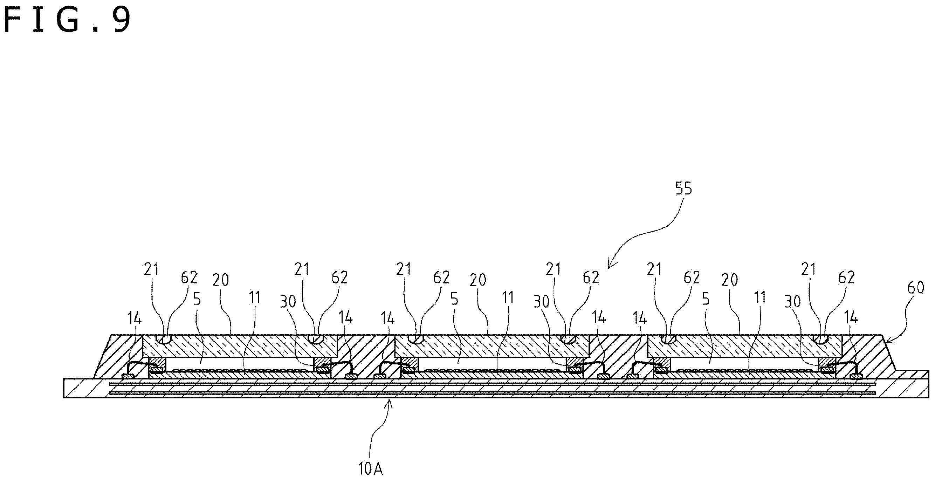

FIG. 9 is a side cross-sectional view of an organic substrate package provided with a mold resin portion in the method for manufacturing a solid-state imaging apparatus.
[FIG. 10]

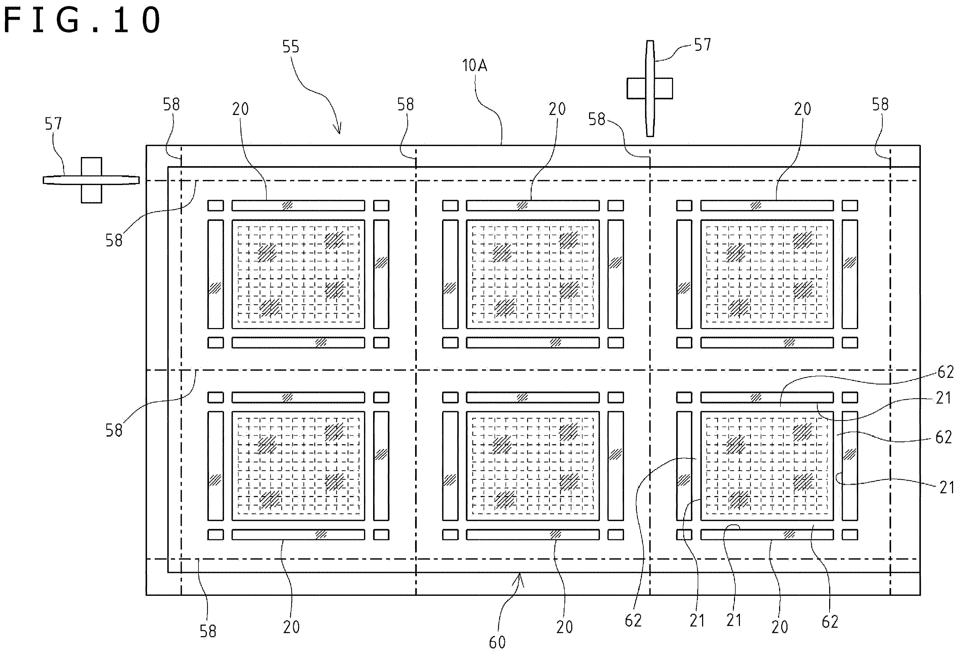

FIG. 10 is an explanatory diagram of the organic substrate package to be divided in the method for manufacturing a solid-state imaging apparatus.
[FIG. 11]

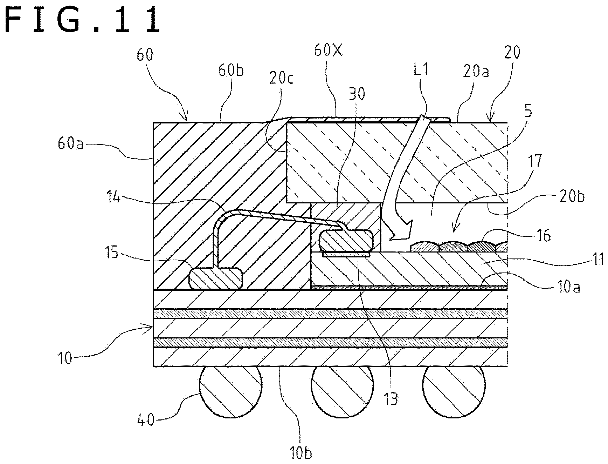

FIG. 11 is an explanatory diagram of the cover glass provided with no groove.
[FIG. 12]

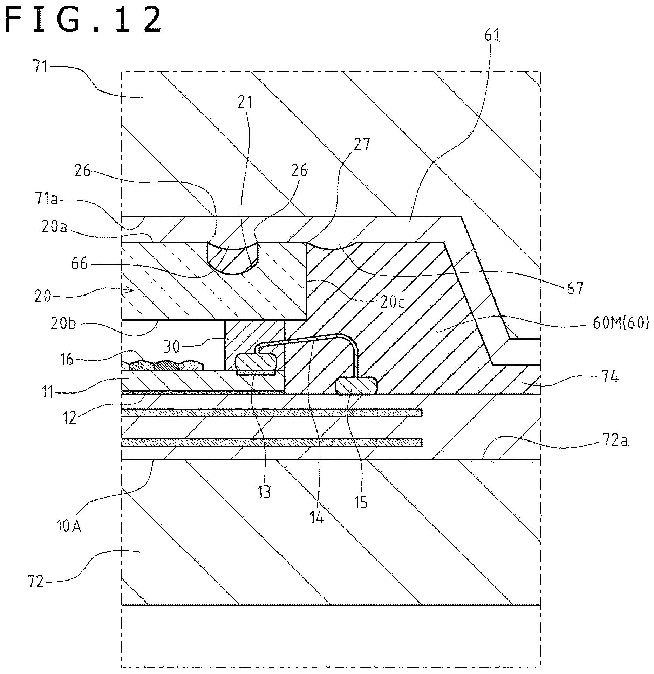

FIG. 12 is an enlarged cross-sectional view of a portion B1 in FIG. 8.
[FIG. 13]

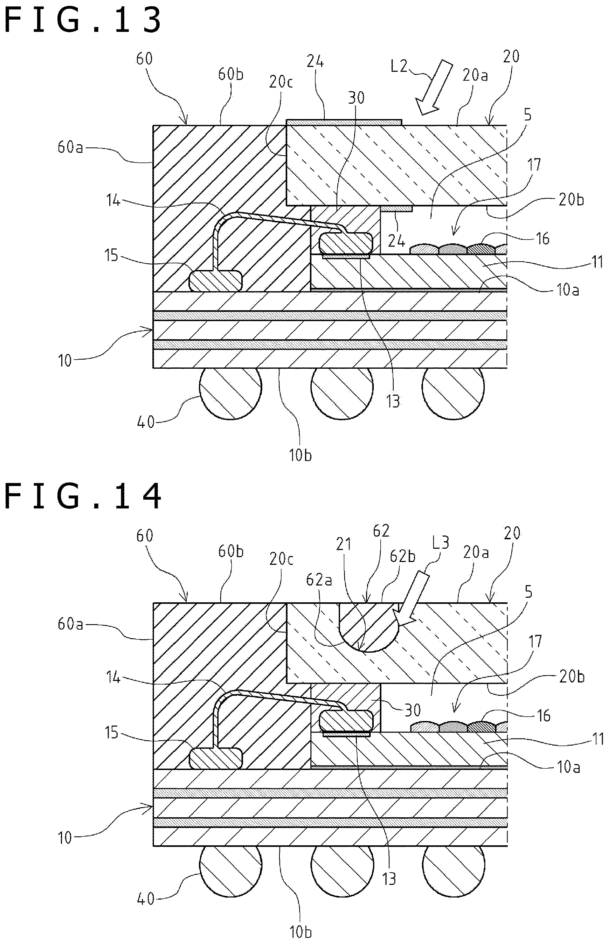

FIG. 13 is an enlarged front view of the cover glass provided with a light blocking film on a front surface or a back surface of the cover glass.
[FIG. 14]
FIG. 14 is an explanatory diagram for effects of the solid-state imaging apparatus according to the first embodiment of the present disclosure.
[FIG. 15]

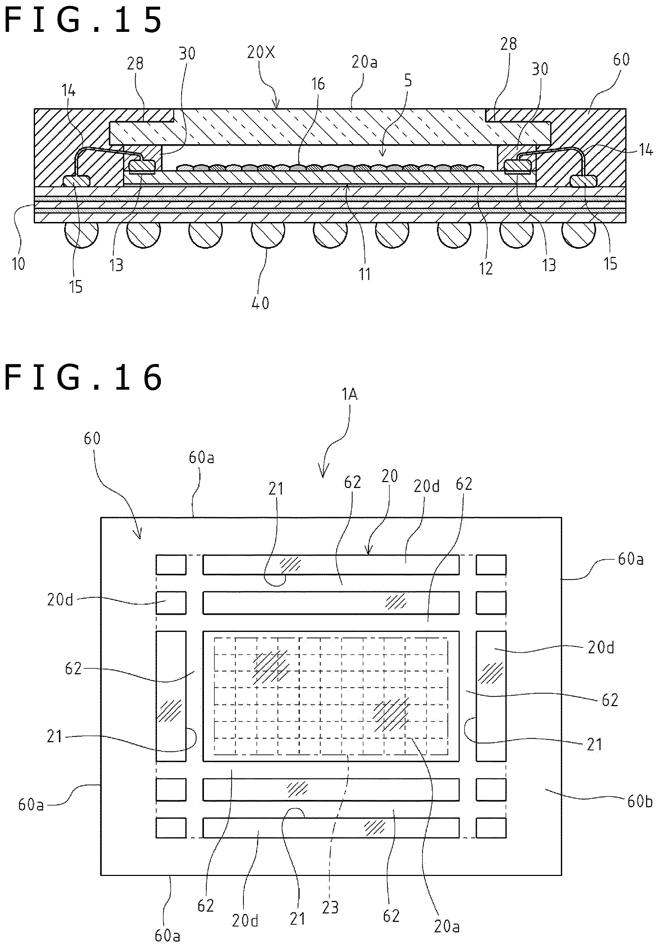

FIG. 15 is a cross-sectional view of the solid-state imaging apparatus including stepped cover glass, the cross-sectional view corresponding to FIG. 2.
[FIG. 16]
FIG. 16 is a plan view depicting a configuration example of a solid-state imaging apparatus according to a second embodiment of the present disclosure.
[FIG. 17]

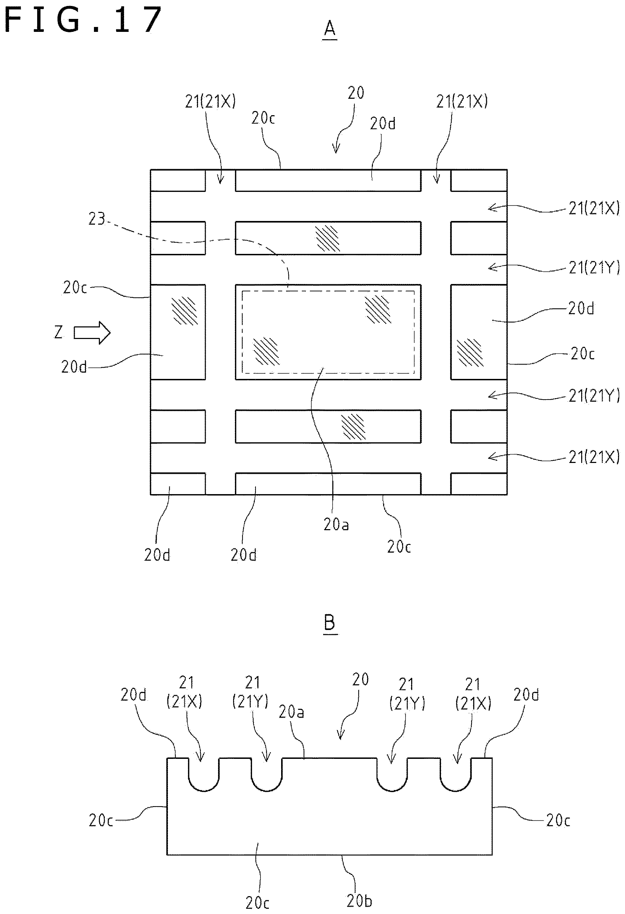

FIG. 17 depicts a plan view and a side view of cover glass provided in the solid-state imaging apparatus according to the second embodiment.
[FIG. 18]

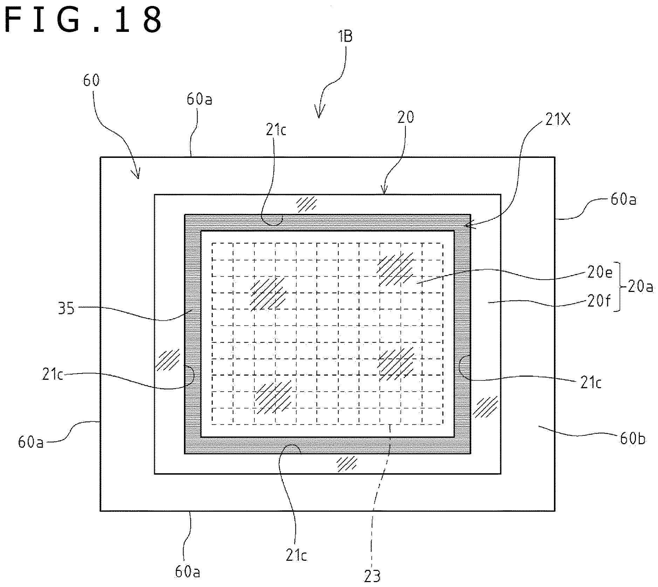

FIG. 18 is a plan view depicting a configuration example of a solid-state imaging apparatus according to a third embodiment of the present disclosure.
[FIG. 19]

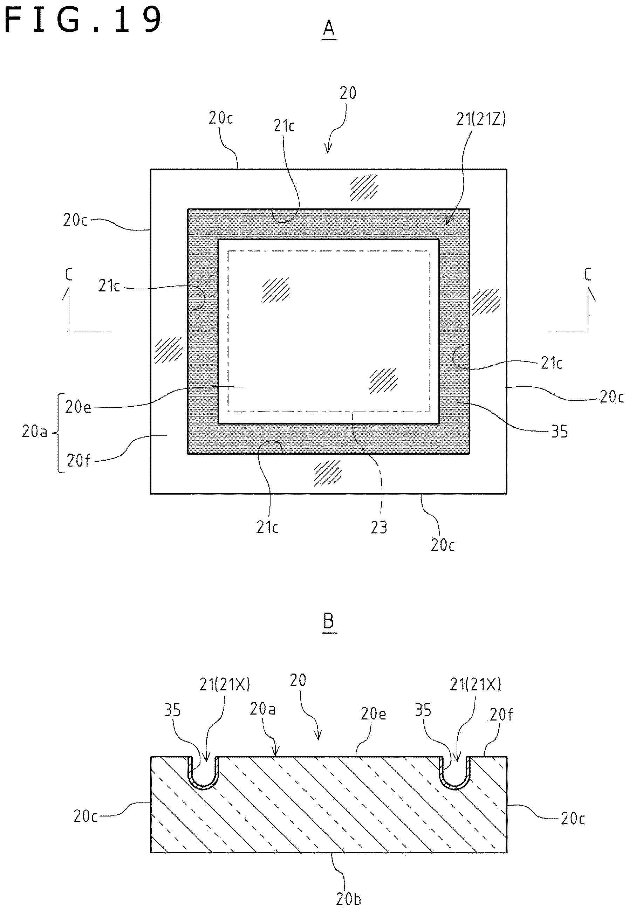

FIG. 19 depicts a plan view and a side view of cover glass provided in the solid-state imaging apparatus according to the third embodiment.
[FIG. 20]

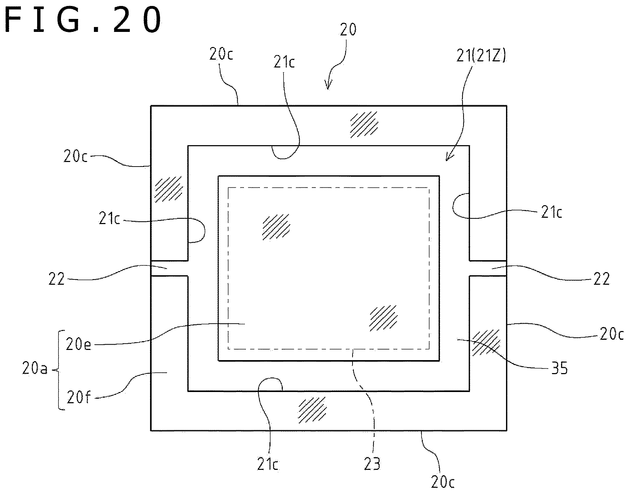

FIG. 20 is a plan view of a variation of the cover glass provided in the solid-state imaging apparatus according to the third embodiment.
[FIG. 21]

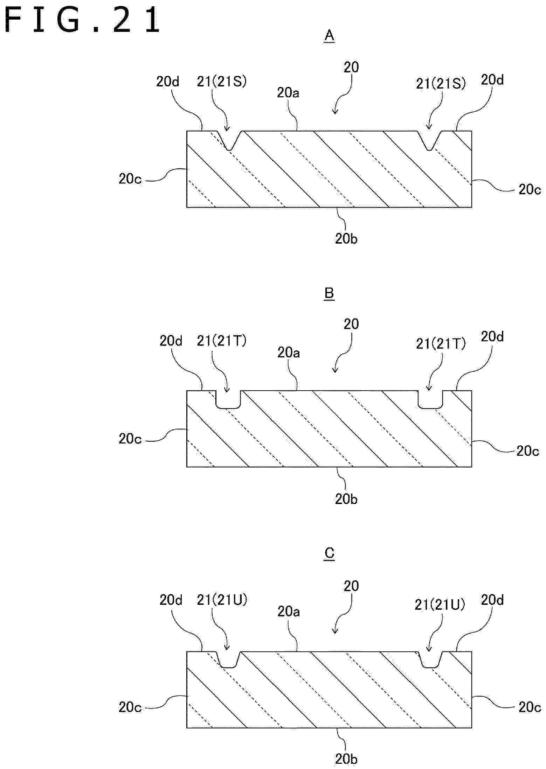

FIG. 21 is an explanatory diagram depicting an example of the horizontal cross-sectional shape of groove portions in the cover glass.
[FIG. 22]

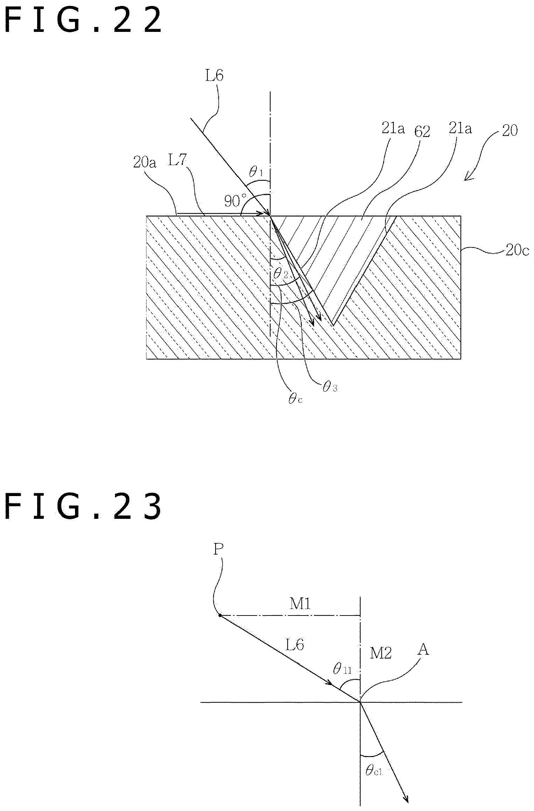

FIG. 22 is a diagram illustrating refraction occurring when a light beam is incident on the cover glass.
[FIG. 23]
FIG. 23 is a diagram illustrating a maximum value of a refracting angle of a light beam actually incident through a lens.
[FIG. 24]

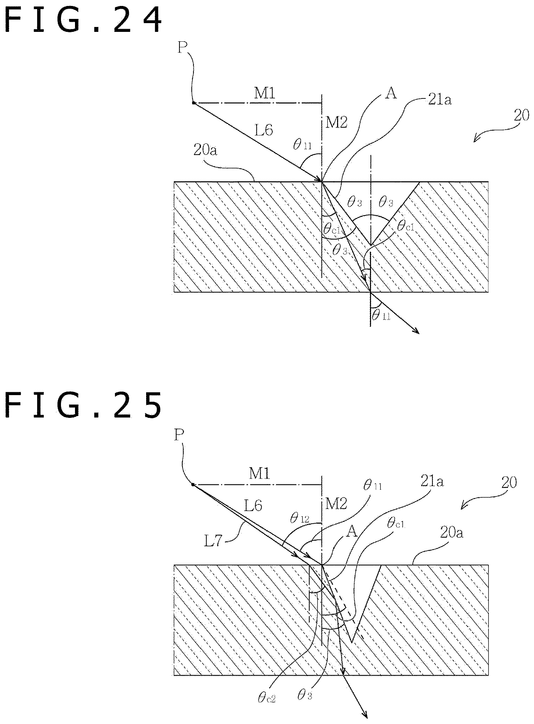

FIG. 24 is a diagram illustrating refraction occurring in a case where a light beam is not reflected from a solid-state imaging element when the light beam is incident on a V-shaped groove portion of the cover glass.
[FIG. 25]
FIG. 25 is a diagram illustrating reflection of light occurring in a case where an angle Θ3 of the groove portion is smaller than a maximum refracting angle θc1 but is not very small.
[FIG. 26]

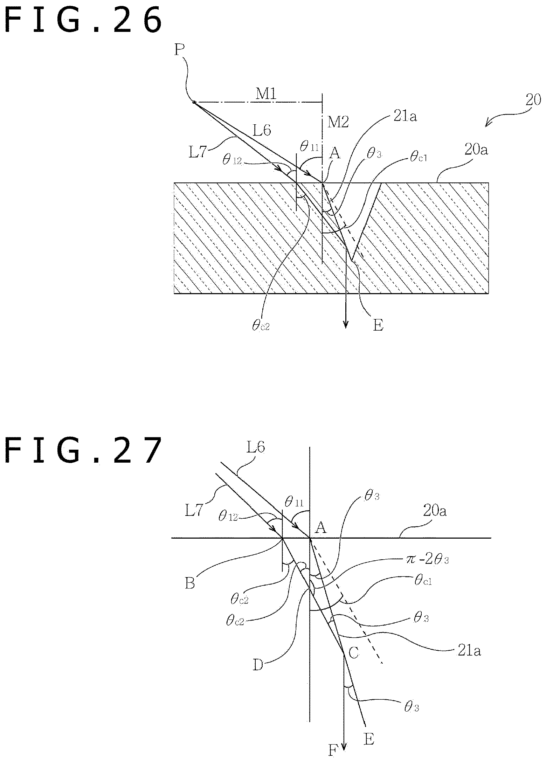

FIG. 26 is a diagram illustrating a lower limit value of the angle of the groove portion, at which the light beam is incident on the V-shaped groove portion of the cover glass and is not reflected from the solid-state imaging element.
[FIG. 27]
FIG. 27 is an enlarged view for describing FIG. 25.
[FIG. 28]

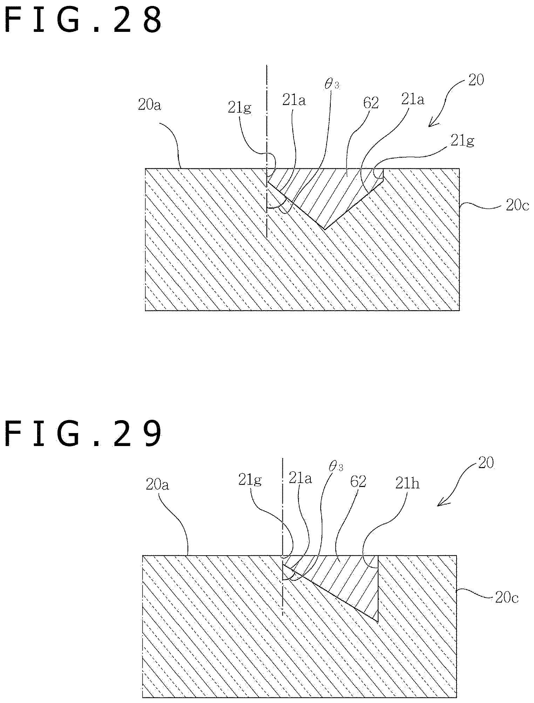

FIG. 28 is an explanatory diagram illustrating an example of the transverse cross-sectional shape of the V-shaped groove portion of the cover glass (1).
[FIG. 29]
FIG. 29 is an explanatory diagram illustrating an example of the transverse cross-sectional shape of the V-shaped groove portion of the cover glass (2).
[FIG. 30]

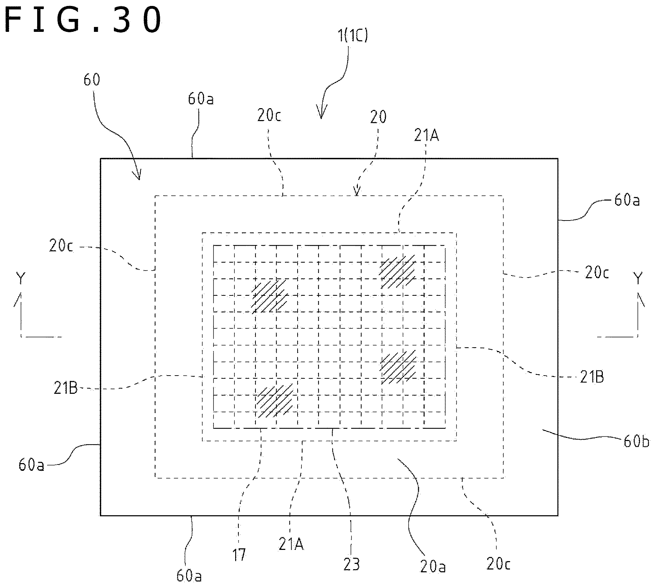

FIG. 30 is a plan view depicting a configuration example of a solid-state imaging apparatus according to a fourth embodiment of the present disclosure.
[FIG. 31]

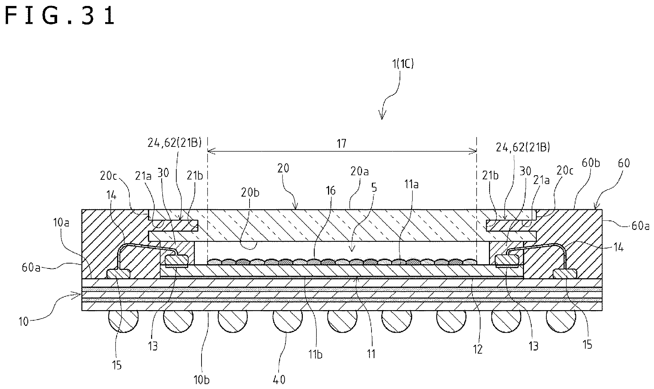

FIG. 31 is a cross-sectional view taken along line Y-Y in FIG. 30.
[FIG. 32]

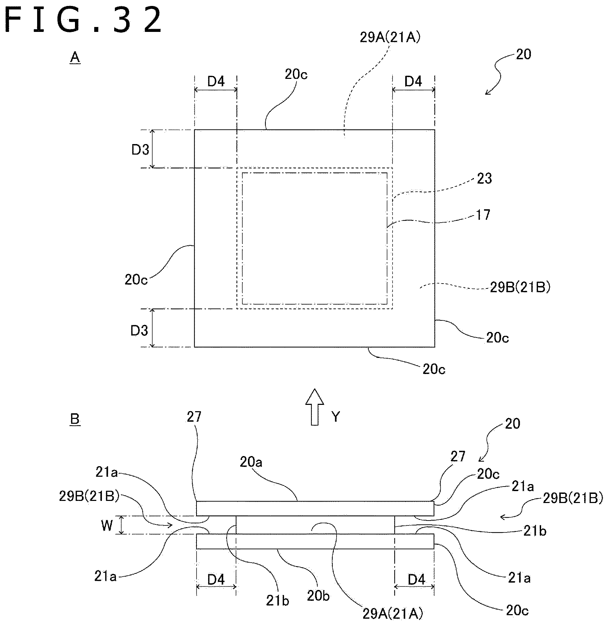

FIG. 32 depicts a plan view and a side view of cover glass used in the solid-state imaging apparatus according to the fourth embodiment of the present disclosure.
[FIG. 33]

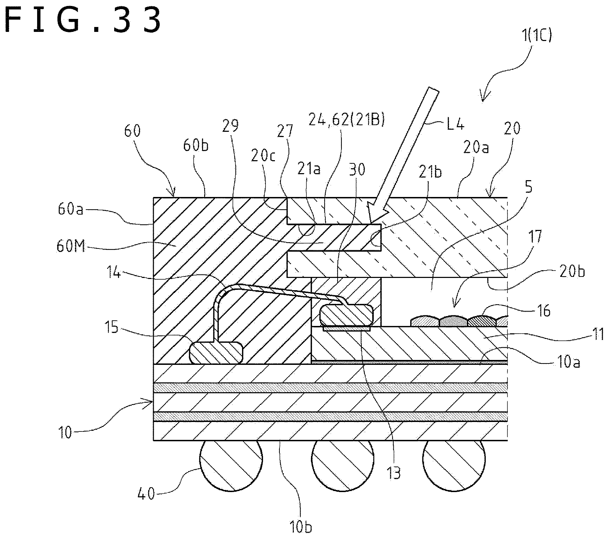

FIG. 33 is an explanatory diagram for effects of the solid-state imaging apparatus according to the fourth embodiment of the present disclosure.
[FIG. 34]

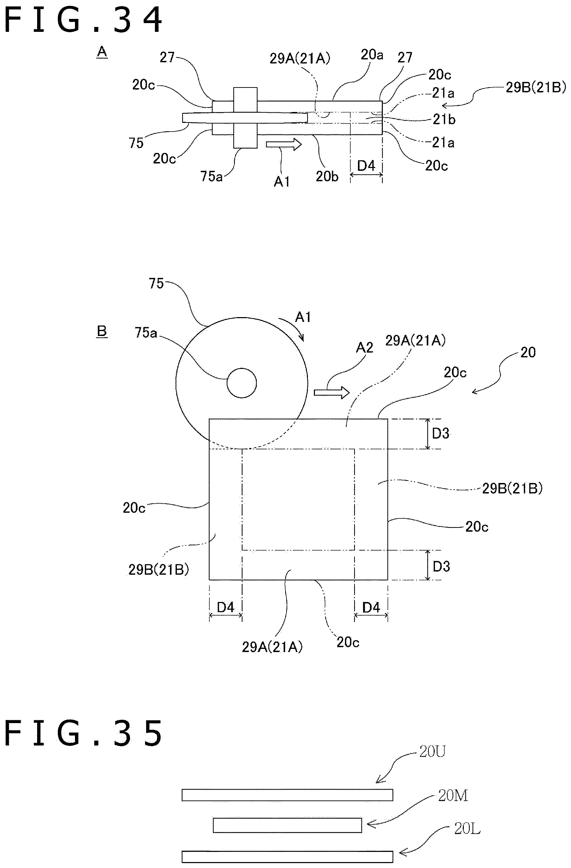

FIG. 34 is an explanatory diagram of a basic form of the step of forming a groove portion in a side surface of the cover glass in a method for manufacturing a solid-state imaging apparatus.
[FIG. 35]
FIG. 35 is an explanatory diagram of Variation 1 of the step of forming a groove portion in the side surface of the cover glass in a method for manufacturing a solid-state imaging apparatus (1).
[FIG. 36]

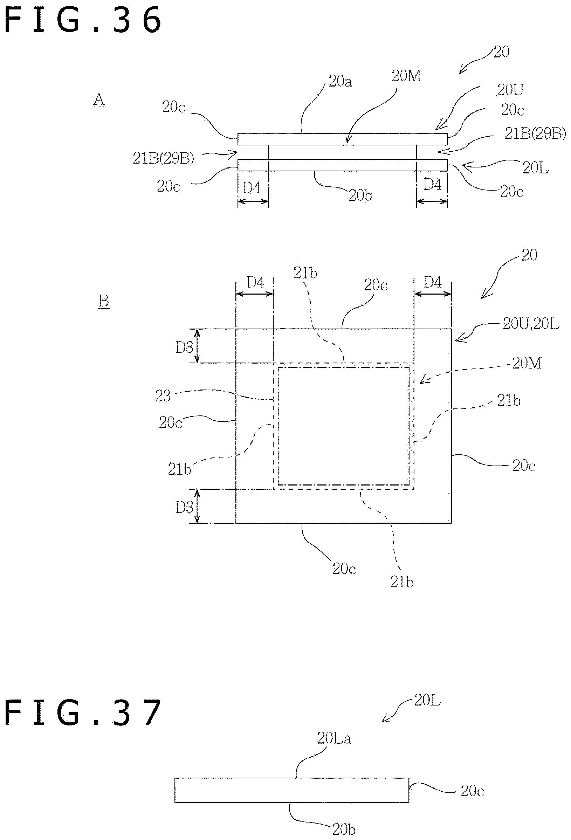

FIG. 36 is an explanatory diagram of Variation 1 of the step of forming a groove portion in the side surface of the cover glass in the method for manufacturing a solid-state imaging apparatus (2).

[FIG. 37]

FIG. 37 is an explanatory diagram of Variation 2 of the step of forming a groove portion in the side surface of the cover glass in the method for manufacturing a solid-state imaging apparatus (1).

[FIG. 38]

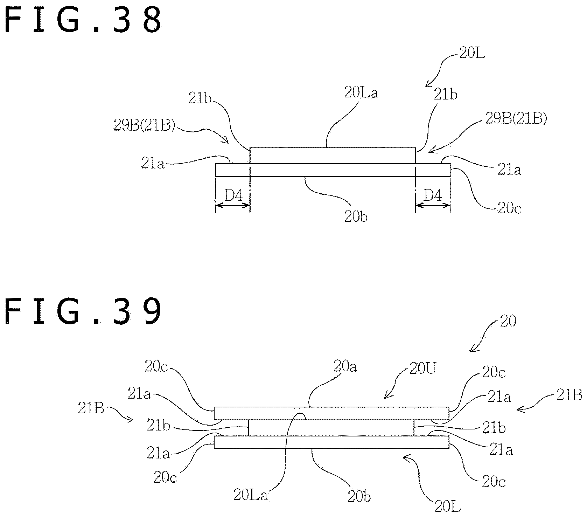

FIG. 38 is an explanatory diagram of Variation 2 of the step of forming a groove portion in the side surface of the cover glass in the method for manufacturing a solid-state imaging apparatus (2).

[FIG. 39]

FIG. 39 is an explanatory diagram of Variation 2 of the step of forming a groove portion in the side surface of the cover glass in the method for manufacturing a solid-state imaging apparatus (3).

[FIG. 40]

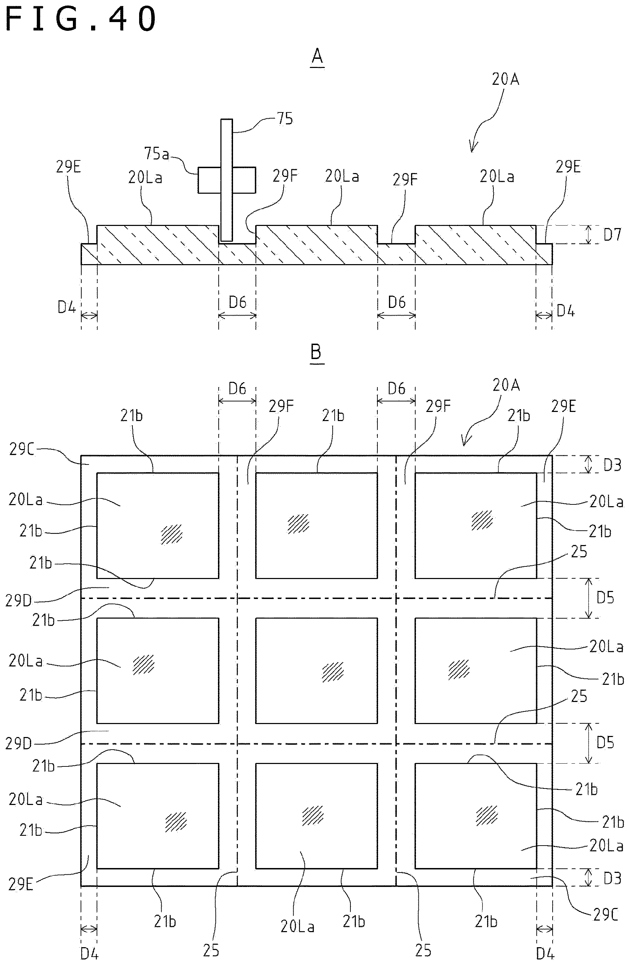

FIG. 40 is an explanatory diagram of the step of dividing a glass panel provided with grooves in the solid-state imaging apparatus according to the fourth embodiment of the present disclosure.

[FIG. 41]

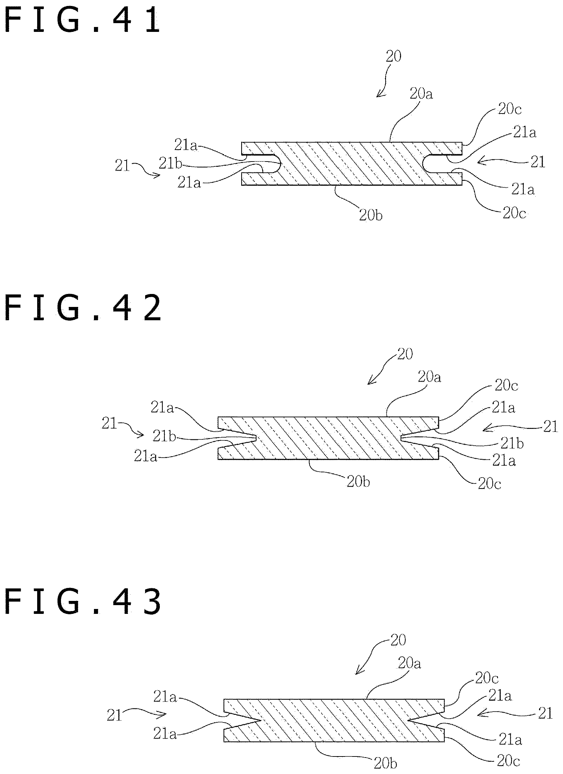

FIG. 41 is an explanatory diagram illustrating an example of the transverse cross-sectional shape of groove portions in the cover glass (1) .

[FIG. 42]

FIG. 42 is an explanatory diagram illustrating an example of the transverse cross-sectional shape of groove portions in the cover glass (2) .

[FIG. 43]

FIG. 43 is an explanatory diagram illustrating an example of the transverse cross-sectional shape of groove portions in the cover glass (3) .

[FIG. 44]

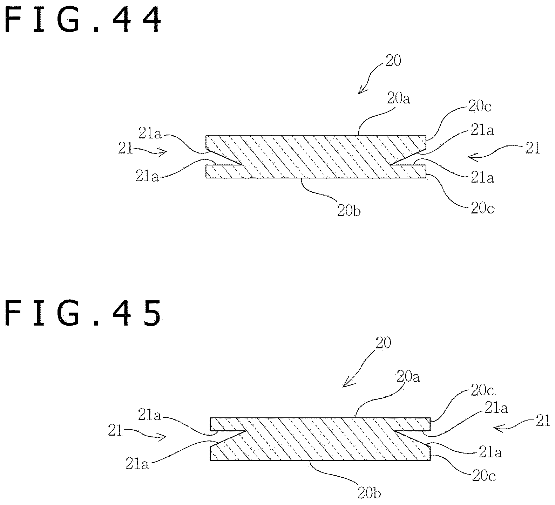

FIG. 44 is an explanatory diagram illustrating an example of the transverse cross-sectional shape of groove portions in the cover glass (4) .

[FIG. 45]

FIG. 45 is an explanatory diagram illustrating an example of the transverse cross-sectional shape of groove portions in the cover glass (5) .

[FIG. 46]

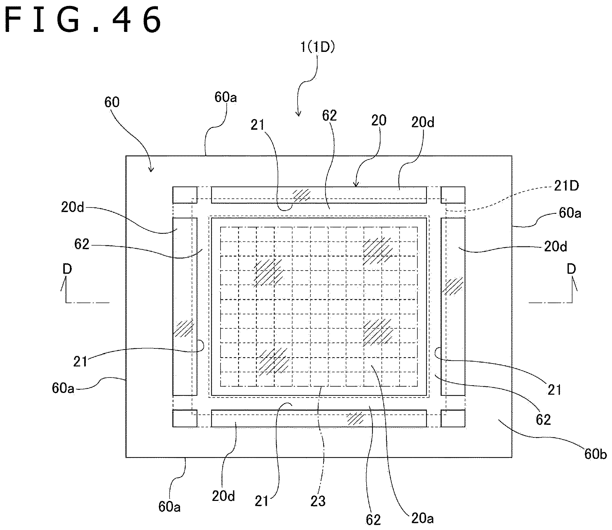

FIG. 46 is a plan view depicting a configuration example of a solid-state imaging apparatus according to a fifth embodiment of the present disclosure.

[FIG. 47]

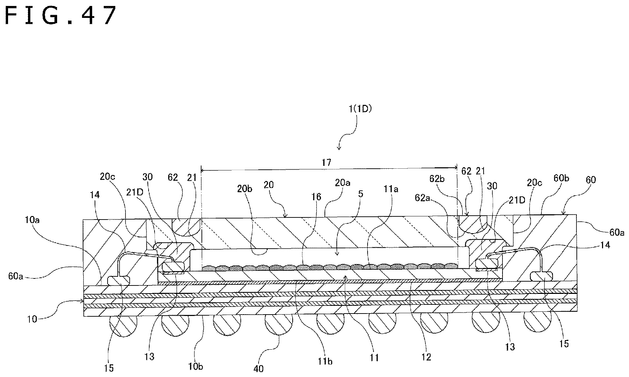

FIG. 47 is a cross-sectional view taken along line D-D in FIG. 47.

[FIG. 48]

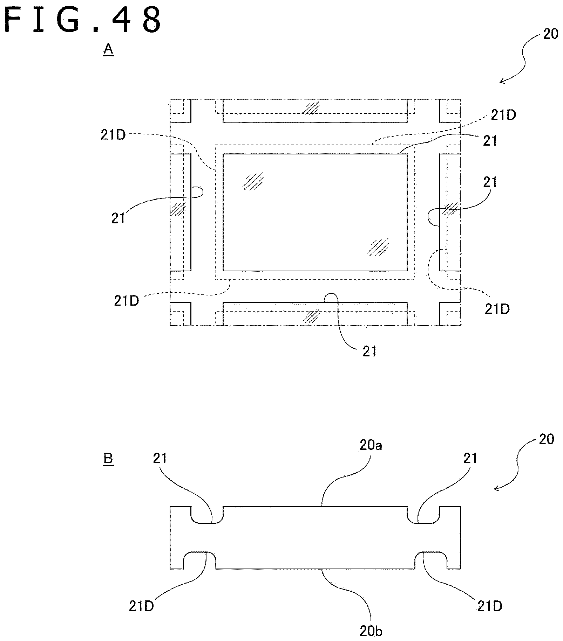

FIG. 48 depicts a plan view and a side view of cover glass used in the solid-state imaging apparatus according to the fifth embodiment of the present disclosure.

[FIG. 49]

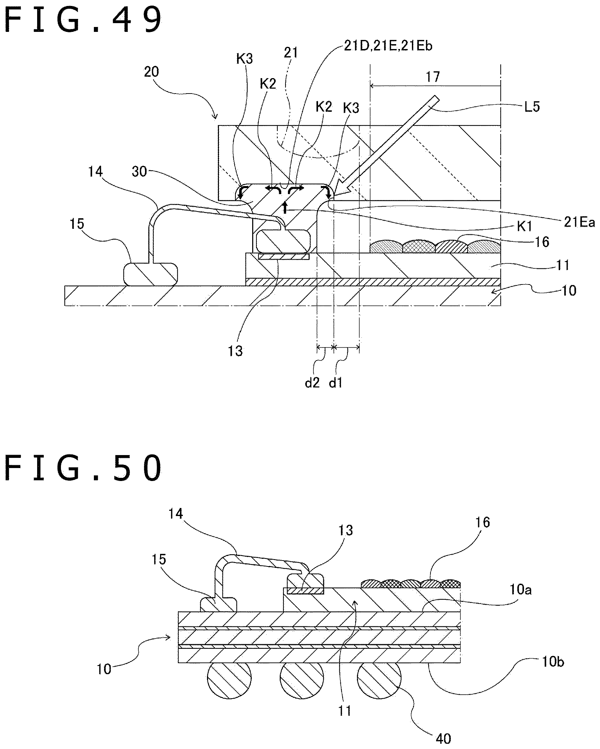

FIG. 49 is a cross-sectional view illustrating the details of the structure of a solid-state imaging apparatus according to the fifth embodiment and a sixth embodiment of the present disclosure.

[FIG. 50]

FIG. 50 is an explanatory diagram for a first method for bonding cover glass in the solid-state imaging apparatus according to the fifth embodiment of the present disclosure (1).

[FIG. 51]

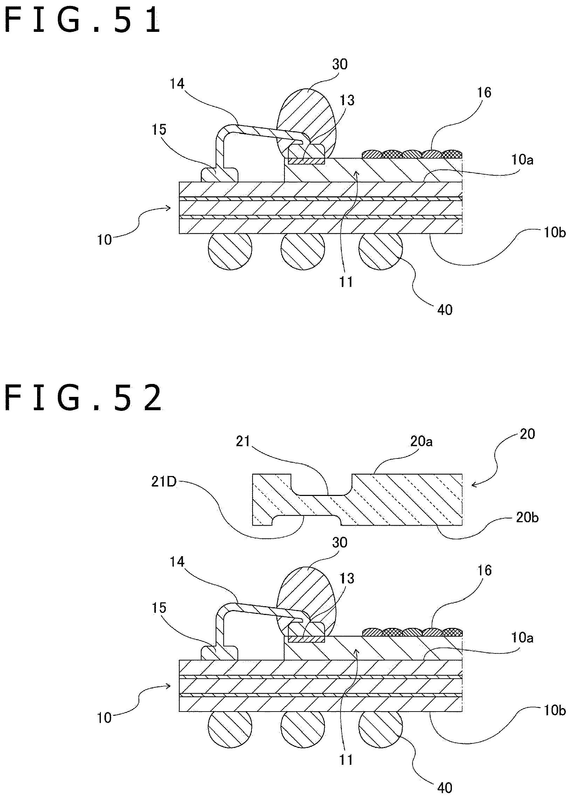

FIG. 51 is an explanatory diagram for the first method for bonding cover glass in the solid-state imaging apparatus according to the fifth embodiment of the present disclosure (2).

[FIG. 52]

FIG. 52 is an explanatory diagram for the first method for bonding cover glass in the solid-state imaging apparatus according to the fifth embodiment of the present disclosure (3).

[FIG. 53]

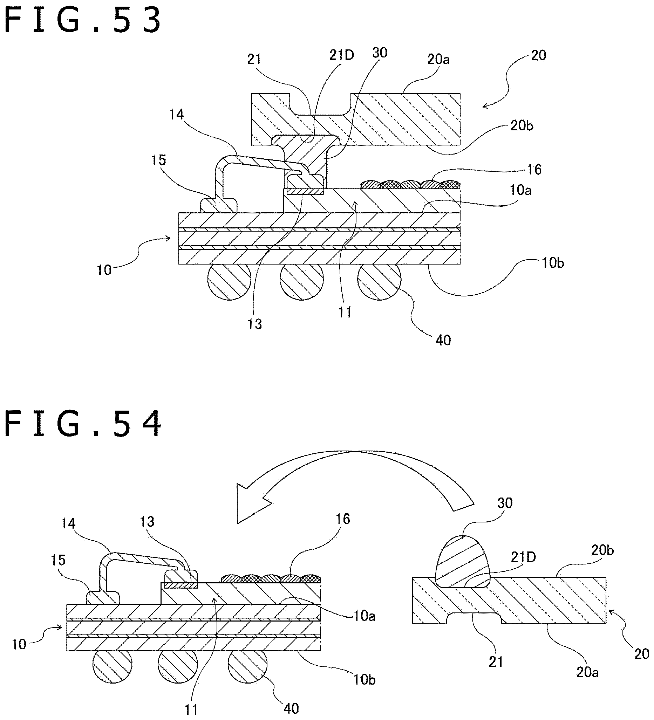

FIG. 53 is an explanatory diagram for the first method for bonding cover glass in the solid-state imaging apparatus according to the fifth embodiment of the present disclosure (4).

[FIG. 54]

FIG. 54 is an explanatory diagram for a second method for bonding cover glass in the solid-state imaging apparatus according to the fifth embodiment of the present disclosure (1).

[FIG. 55]

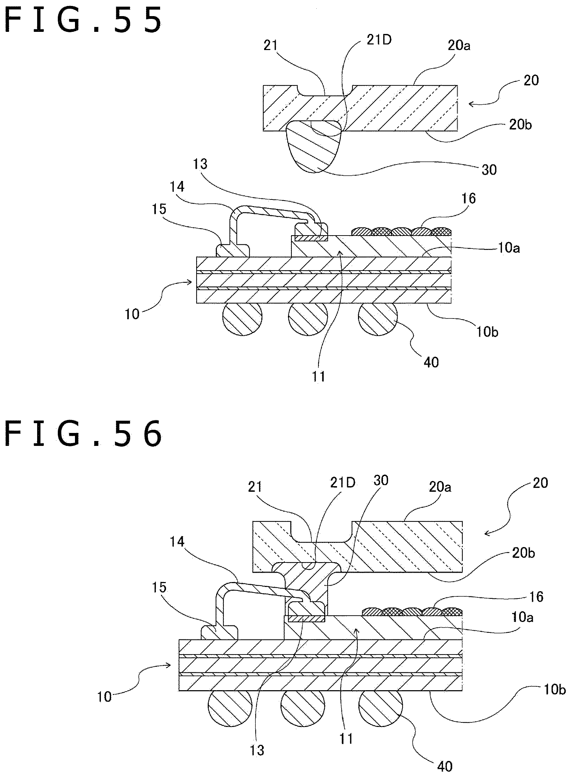

FIG. 55 is an explanatory diagram for the second method for bonding cover glass in the solid-state imaging apparatus according to the fifth embodiment of the present disclosure (2).

[FIG. 56]
FIG. 56 is an explanatory diagram for the second method for bonding cover glass in the solid-state imaging apparatus according to the fifth embodiment of the present disclosure (3).
[FIG. 57]

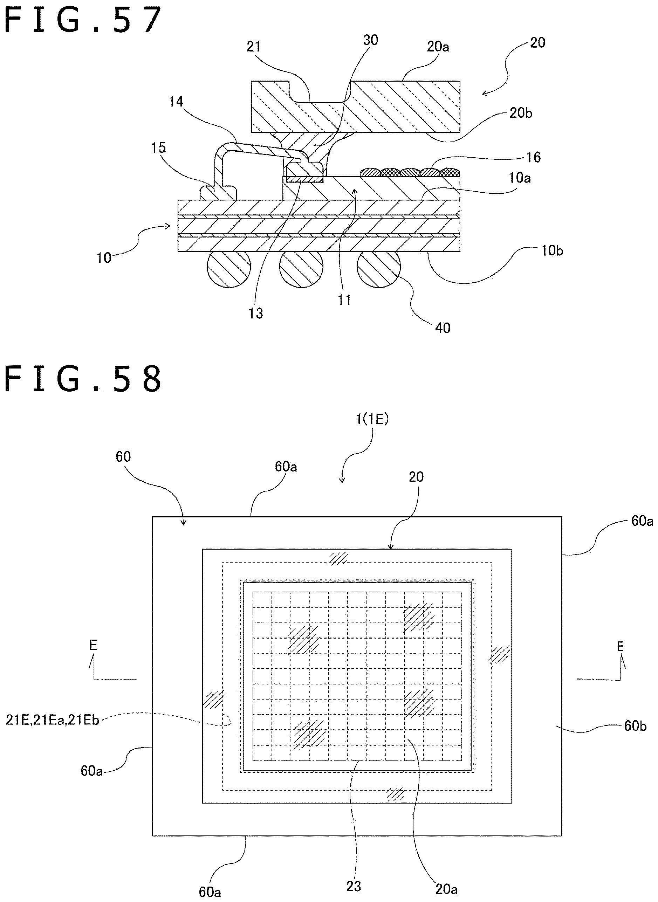

FIG. 57 is an explanatory diagram of the cover glass provided with no groove portion in a back surface of the cover glass.
[FIG. 58]
FIG. 58 is a plan view depicting a configuration example of the solid-state imaging apparatus according to the sixth embodiment of the present disclosure.
[FIG. 59]

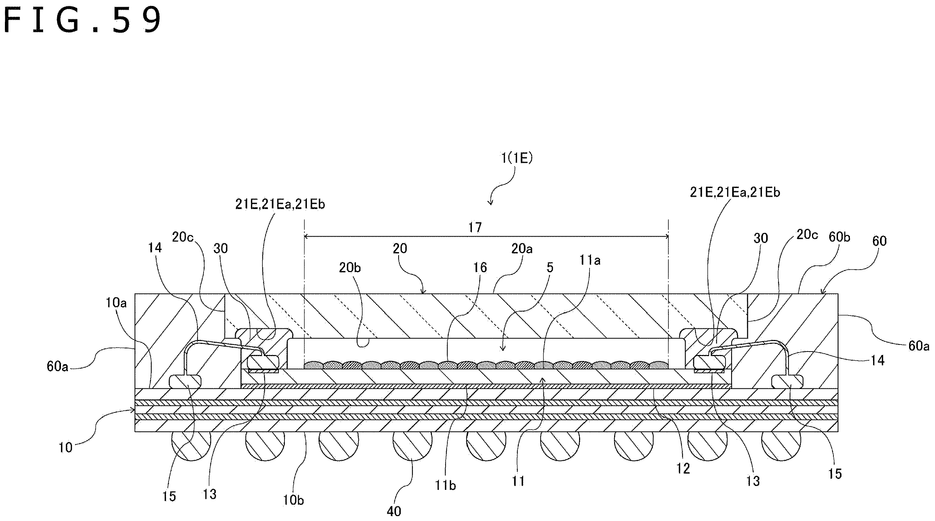

FIG. 59 is a cross-sectional view taken along line E-E in FIG. 58.
[FIG. 60]

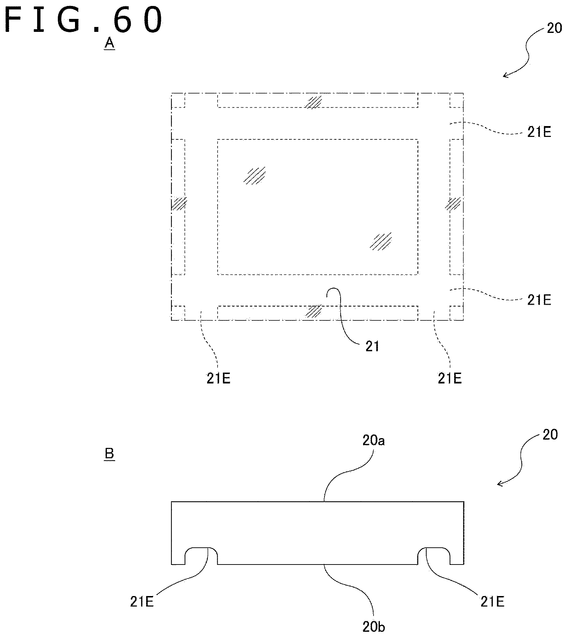

FIG. 60 depicts a plan view and a side view of cover glass used in the solid-state imaging apparatus according to the sixth embodiment of the present disclosure.
[FIG. 61]

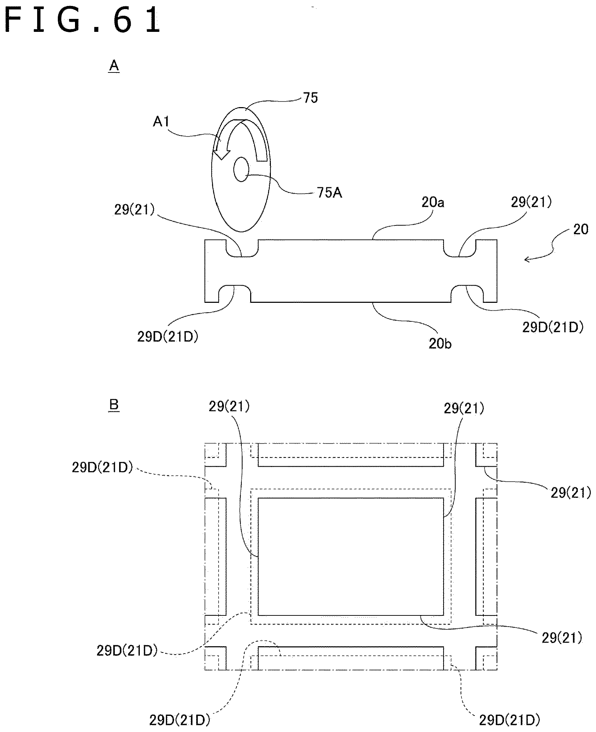

FIG. 61 is an explanatory diagram for the step of forming grooves in the cover glass in a method for manufacturing the solid-state imaging apparatus according to the fifth embodiment of the present disclosure.
[FIG. 62]

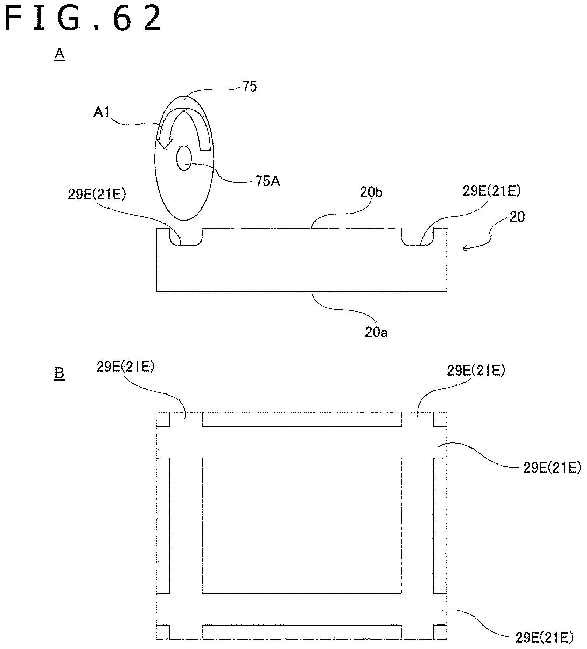

FIG. 62 is an explanatory diagram for the step of forming grooves in the cover glass in a method for manufacturing the solid-state imaging apparatus according to the sixth embodiment of the present disclosure.
[FIG. 63]

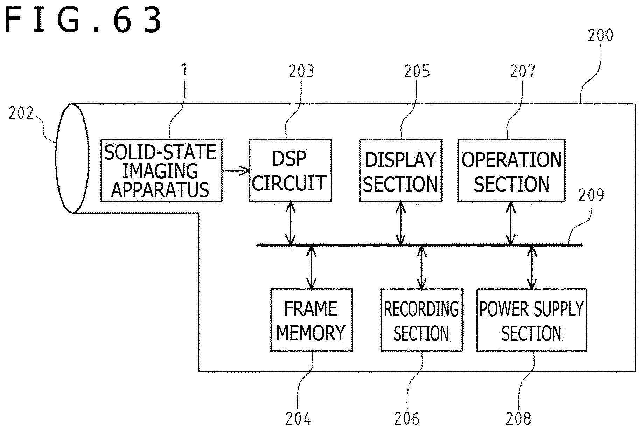

FIG. 63 is a block diagram depicting a configuration example of electronic equipment including the solid-state imaging apparatus according to an embodiment of the present disclosure.

[Description of Embodiments]

Now, with reference to the drawings, forms for implementing a technology according to the present disclosure (hereinafter also referred to as "embodiments") will be described in the following order. Note that identical or similar portions in the drawings described below are denoted by identical or similar reference signs. Additionally, the drawings are schematic, and the ratio of dimensions of portions and the like do not necessarily match the actual ones.

1. Configuration Example of Solid-state Imaging Apparatus according to First Embodiment

2. Method for Manufacturing Solid-state Imaging Apparatus according to First Embodiment

3. Configuration Example of Solid-state Imaging Apparatus according to Second Embodiment

4. Configuration Example of Solid-state Imaging Apparatus according to Third Embodiment

5. Configuration Example of Solid-state Imaging Apparatus according to Fourth Embodiment

6. Method for Manufacturing Solid-state Imaging Apparatus according to Fourth Embodiment

7. Configuration Example of Solid-state Imaging Apparatus according to Fifth Embodiment

8. Configuration Example of Solid-state Imaging Apparatus according to Sixth Embodiment

9. Method for Manufacturing Solid-state Imaging Apparatus according to Fifth Embodiment and Sixth Embodiment

10. Configuration Example of Electronic Equipment

<1. Configuration Example of Solid-state Imaging Apparatus according to First Embodiment>

FIG. 1 is a plan view depicting a configuration example of a solid-state imaging apparatus 1 according to a first embodiment of the present disclosure. Additionally, FIG. 2 is a cross-sectional view taken along line X-X in FIG. 1. As depicted in FIGS. 1 and 2, the solid-state imaging apparatus 1 includes an organic substrate 10 used as a substrate, an image sensor 11 provided on the organic substrate and corresponding to a solid-state imaging element, and cover glass 20 provided on the image sensor 11 via a dam material 30 corresponding to a support portion. In the solid-state imaging apparatus 1, the image sensor 11 is bonded onto the organic substrate 10, a bonding wire 14 is used to connect the organic substrate 10 and the image sensor 11, and the cover glass 20 is mounted on the image sensor 11 via the dam material 30. A cavity 5 shaped like a void is formed between the image sensor 11 and the cover glass 20 and is peripherally sealed by the dam material 30.

The organic substrate 10 includes, as a base material, an organic material such as plastic which corresponds to an insulating material, and has a configuration in which circuit patterns including metal patterns are laminated. In the organic substrate 10, a wiring layer is formed by, for example, forming through-holes and connecting the metal patterns together in a vertical direction. The organic substrate 10 is a rectangular plate-like member and includes a front surface 10a on which the image sensor 11 is mounted, and a bottom surface 10b opposite to the front surface 10a. The image sensor 11 is die-bonded onto the front surface 10a side of the organic substrate 10 via a bonding layer 12 including, for example, an insulating die bond material.

The bottom surface 10b of the organic substrate 10 includes multiple external connection terminals 40 disposed in a grid and including solder balls for mounting on a printed circuit board of electronic equipment (not depicted) by soldering, leading to BGA (ball grid array) configuration. Note that a reflow furnace is used for soldering to the printed circuit board mounted in the electronic equipment or the like.

The image sensor 11 is a chip shaped like a rectangular plate and including a semiconductor substrate including silicon (Si) corresponding to an example of a semiconductor. A light receiving side corresponds to a front surface 11a side of the image sensor 11, which is one of the plate surfaces, and the opposite plate surface is referred to as a back surface 11b. The front surface 11a of the image sensor 11 is provided with multiple light receiving elements. The image sensor 11 is of a CMOS type. However, the image sensor 11 may be of a CCD type.

The image sensor 11 includes, on the front surface 11a side, a light receiving area 17 corresponding to a pixel area including a large number of pixels 16 formed in a predetermined array, for example, a Bayer array. An area around the light receiving area 17 is defined as a peripheral area. The pixels 16 in the light receiving area 17 each include a photodiode used as a photoelectric conversion section having a photoelectric conversion function, and multiple pixel transistors.

On the front surface 11a side of the image sensor 11, a color filter layer and a micro lens array are disposed on top of each other via an antireflection film, a planarization film, and the like over a semiconductor substrate, the color filter layer including color filters formed corresponding to the pixels 16, the antireflection film including an oxide film or the like, the planarization film including an organic material. The photodiode receives, via the color filter layer, the planarization film, and the like, light incident on the micro lens array.

The cover glass 20 is an example of a transparent member and is a member externally shaped like a rectangular plate. The cover glass 20 has approximately the same external dimensions as those of the image sensor 11 in plan view. On the light receiving side of the image sensor 11, the cover glass 20 has approximately the same external shape as that of the image sensor 11 in plan view, and is provided parallel to and at a predetermined distance to the image sensor 11. The cover glass 20 includes a back surface 20b corresponding to a plate surface facing the image sensor 11, a front surface 20a opposite to the back surface 20b, and side surfaces 20c in four directions. The cover glass 20 is supported by being fixed by the dam material 30 to the image sensor 11.

The cover glass 20 transmits light incident from the front surface 20a side. The light transmitted through the cover glass 20 reaches a light receiving surface of the image sensor 11 via the cavity 5. The cover glass 20 has a function to protect the light receiving surface side of the image sensor 11. Note that, instead of the cover glass 20, for example, a plastic plate, a silicon plate that transmits only infrared light, or the like can be used.

On the front surface 11a side of the image sensor 11, multiple electrode pads 13 are provided as terminals for transmitting and receiving signals to and from the outside. The electrode pads 13 are covered with the dam material 30 in a peripheral area on the front surface 11a side of the image sensor 11. However, the arrangement positions of the electrode pads 13 are not particularly limited. Additionally, the front surface 10a of the organic substrate 10 is provided with multiple lead terminals 15.

The electrode pads 13 of the image sensor 11 are electrically connected to the lead terminals 15 of the organic substrate 10 by bonding wires 14. The bonding wires 14 include thin metal lines including, for example, Au (gold) or Cu (copper). The lead terminals 15 of the organic substrate 10 are electrically connected to the external connection terminals 40 provided on the bottom surface 10b side of the organic substrate 10.

In the configuration described above, the image sensor 11 generates an imaging signal by receiving light via the microlens array and the color filter layer, and the imaging signal is converted into an electric signal, and is connected to an external circuit from the external connection terminals 40 through the electrode pads 13, the bonding wires 14, the lead terminals 15, and the wiring layer formed in the organic substrate 10.

The dam material 30 prevents a mold resin portion 60 described below from infiltrating into the cavity 5 and has a function to bond the cover glass 20 to the image sensor 11. The dam material 30 is provided in a peripheral area outside the light receiving area 17. The dam material 30 is interposed between the image sensor 11 and the cover glass 20 to bond the image sensor 11 and the cover glass 20 together, with the image sensor 11 and the cover glass 20 spaced apart from each other. The dam material 30 also functions as a sealing portion sealing the periphery of the cavity 5.

The dam material 30 is formed like a wall all along the external shape of the cover glass 20 and is shaped like a rectangular frame in plan view. The dam material 30 is formed over the electrode pads 13 and over connection portions of the bonding wires 14 to the electrode pads 13. However, a formation region of the dam material 30 is particularly limited.

The dam material 30 includes an insulating material. Specifically, a material for the dam material 30 is, for example, a photosensitive adhesive such as a UV (ultraviolet) curing resin which corresponds to an acrylic resin, a thermosetting resin such as an epoxy resin, or a mixture thereof. The dam material 30 is formed on the front surface 11a of the image sensor 11 by application through a dispenser, patterning using photolithography, or the like. Note that, according to the present technology, the support portion is not limited to the resin, but any configuration may be provided by applying a structure including ceramics such as glass or an inorganic material such as metal or silicon, to the image sensor 11 and the cover glass 20 with an adhesive or the like.

The solid-state imaging apparatus 1 includes the mold resin portion 60 formed around the image sensor 11 and the cover glass 20 in a peripheral edge portion of the organic substrate 10. That is, the mold resin portion 60 covers and seals the periphery of the bonding wires 14 corresponding to a portion outside the cavity 5 on the organic substrate 10. The mold resin portion 60 includes side surfaces 60a that are continuous and flush with the side surfaces of the organic substrate 10 and an upper surface 60b that is continuous and flush with the front surface 20a of the cover glass 20.

A material for the mold resin portion 60 is, for example, a thermosetting resin containing a filler containing silicon oxide as a main component. In particular, the mold resin portion 60 includes a material having a light blocking effect in the present embodiment. Specifically, a material constituting the mold resin portion 60 is a black resin material containing a black pigment such as carbon black or titanium black. The mold resin portion 60 is formed into a predetermined shape by injection molding using a mold tool 70.

In the solid-state imaging apparatus 1 according to the present embodiment including the above-described configuration, as illustrated in FIG. 1, FIG. 2, and FIG. 3, the front surface 20a side of the cover glass 20 is provided with groove portions 21 in regions outside a light receiving area portion 23 that is a light receiving area corresponding to the light receiving area 17 of the image sensor 11. That is, on the front surface 20a of the cover glass 20, the groove portions 21 are formed in the regions outside the area of the light receiving area portion 23 corresponding to a projection area of the light receiving area 17 of the image sensor 11 in plan view. Note that FIG. 3A is a plan view of the cover glass 20 and that FIG. 3B is a side view of the cover glass 20 (as seen from a Y direction indicated by an arrow in FIG. 3A).

Specifically, as depicted in FIG. 1, the groove portions 21 are linearly formed along four sides of the cover glass 20 outside the area of the light receiving area portion 23 on the front surface 20a of the cover glass 20 shaped like a rectangular plate. That is, one groove portion 21 is engraved along each side of the cover glass 20 that is shaped like a rectangle in plan view. The groove portions 21 are formed inside edge ends of the cover glass 20. Consequently, margin portions 20d constituting a flat front surface 20a are present in peripheral portions of the front surface 20a of the cover glass 20.

Each of the groove portions 21 opens to the side surface 20c of the cover glass 20 on both sides in an extension direction. In other words, the groove portion 21 is formed continuously from one of the side surfaces 20c of the cover glass 20 to the opposite side surface 20c. Consequently, an intersection portion 21r is formed near each of four corners of the cover glass 20, and adjacent groove portions 21 intersect each other at the intersection portion 21r.

The groove portion 21 is shaped like a generally semicircle in transverse cross-sectional view, and generally has a constant depth D1 (see FIG. 3B). In detail, the groove portion 21 includes inner side surfaces 21a corresponding to generally vertical flat surfaces facing the width direction of the groove and a bottom surface 21b that is curved and shaped like a semicircle in transverse cross-sectional view. The groove portion 21 has a symmetrical shape with respect to the width direction of the groove. The depth D1 of the groove portion 21 is, for example, approximately one-third to one-half of a plate thickness D2 of the cover glass 20. Here, the depth D1 of the groove portion 21 is a dimension from a lower end of the groove portion 21 to the front surface 20a of the cover glass 20 in a plate thickness direction (up-down direction in FIG. 3B).

By way of example only, the portions of the cover glass 20 have the following dimensions. The cover glass 20 has a thickness of from approximately 400 to 500 $\mu$m. The groove portion 21 has a width of from approximately 200 to 300 $\mu$m. The groove portion 21 has a depth of from approximately 100 to 250 $\mu$m.

The groove portion 21 is internally provided with an in-groove resin portion 62 including the same material as that of the mold resin portion 60. The in-groove resin portion 62 is formed to follow the shape of the groove portion 21 and the external shape of the cover glass 20. Consequently, the in-groove resin portion 62 includes a groove contact surface 62a extending along the inner side surfaces 21a and bottom surface 21b forming the groove portion 21, and a flat surface portion 62b that is flush with the front surface 20a of the cover glass 20. In this manner, the groove portion 21 is internally filled with the material forming the mold resin portion 60 and having a light blocking effect, thus forming a light blocking film 24.

<2. Method for Manufacturing Solid-state Imaging Apparatus according to First Embodiment>

Now, a method for manufacturing the solid-state imaging apparatus 1 according to the first embodiment will be described on the basis of the drawings. FIG. 4 and FIG. 5 are explanatory diagrams illustrating the processing step of processing the cover glass 20 in the method for manufacturing the solid-state imaging apparatus 1. FIGS. 4 to 10 are explanatory diagrams for the method for manufacturing the solid-state imaging apparatus 1.

In the method for manufacturing the solid-state imaging apparatus 1, first, the step of preparing the cover glass 20 is executed, the cover glass 20 being used as a member covering the front surface 11a side of the image sensor 11. The cover glass 20 includes the groove portion 21 with at least one side opening to the side surface 20c of the cover glass 20, in the region outside the light receiving area portion 23 on the front surface 20a side. In the present embodiment, the groove portion 21 opens to the side surface 20c on both sides in the extension direction.

In the step of preparing the cover glass 20, first, as depicted in FIGS. 4A and 4B, a glass panel 20A is prepared that is shaped like a rectangle and has predetermined dimensions, and is used as a material for the cover glass 20. The cover glass 20 is obtained by cutting the glass panel 20A of a large size into pieces of a predetermined size. In other words, the cover glass 20 is obtained by cutting and dividing the glass panel 20A into rectangular pieces.

Then, grooves 29 forming the groove portions 21 in the cover glass 20 are continuously formed along each side of the glass panel 20A. The grooves 29 are formed in the glass panel 20A using an apparatus referred to as a dicer and including a blade 75 for dicing as depicted in FIGS. 4A and 5A. The blade 75 is a grindstone shaped like a disc and can be rotated by a predetermined rotation shaft 75a. That is, the grooves 29 are formed by adjusting the depth position of the blade 75 with respect to a front surface 20Aa of the glass panel 20A and using the rotating blade 75 to linearly cut a part of the front surface 20Aa side of the glass panel 20A to a predetermined depth.

Specifically, as depicted in FIG. 4A, the blade 75, while being rotated (see arrow A1), is moved in a horizontal direction (lateral direction in FIG. 4B) corresponding to a first direction (see arrow A2), and thus grooves 29A are engraved at predetermined intervals as the grooves 29. Then, as depicted in FIG. 5A, the blade 75, while being rotated, is moved in a vertical direction (up-down direction in FIG. 4B) corresponding to a second direction, and thus grooves 29B are engraved at predetermined intervals as the grooves 29. Accordingly, as depicted in FIG. 4B, on the front surface 20Aa of the glass panel 20A, the grooves 29 in the horizontal and vertical directions are formed that correspond to the respective areas of the cover glass 20. The depth of the groove 29 is defined by adjusting the depth of the blade 75 with respect to the front surface 20Aa of the glass panel 20A. Note that it is sufficient if the groove 29 is formed in an area portion corresponding to the cover glass 20 obtained by division and the groove 29 need not necessarily be formed to reach the end of the glass panel 20A.

After the grooves 29 are completely engraved in the glass panel 20A in the horizontal and vertical directions, the step of dividing the glass panel 20A is executed. The glass panel 20A is also divided, for example, by using a dicer including the blade 75 for forming the grooves 29. In this case, the depth position of the blade 75 with respect to the front surface 20Aa of the glass panel 20A is adjusted to the position for cutting. Then, as depicted in FIGS. 5A and 5B, the blade 75 is rotated to dice the glass panel 20A along predetermined cutting lines 25 in the horizontal and vertical directions to cut and divide the glass panel 20A into pieces of the cover glass 20 each with a predetermined size. This results in multiple pieces of the cover glass 20 each shaped like a rectangular plate as depicted in FIGS. 3A and 3B. As described above, the step of preparing the cover glass 20 is executed.

Then, as depicted in FIG. 6, the step of producing a package substrate sheet 50 is executed, the package substrate sheet 50 being obtained by mounting the multiple image sensors 11 on the organic substrate sheet 10A and providing the cover glass 20 on each of the image sensors 11 via the dam material 30. The organic substrate sheet 10A is an integral substrate sheet formed by aggregating organic substrates 10. The organic substrate sheet 10A is provided with multiple laminated circuit patterns for connection to the image sensor 11, which are not depicted. Such multiple circuit patterns are arranged in a grid at predetermined intervals for the respective image sensors 11 bonded to the organic substrate sheet 10A.

On an upper surface of each of the circuit patterns formed on the organic substrate sheet 10A, the image sensor 11, the dam material 30, the cover glass 20, and the like are placed and assembled by bonding. That is, the package substrate sheet 50 is obtained by fixedly bonding the multiple image sensors 11 to the organic substrate sheet 10A in a predetermined array and performing, on each image sensor 11, routing of the bonding wires 14, application of the dam material 30, and mounting of the cover glass 20.

Then, as depicted in FIG. 7, a mold tool 70 is used to form the mold resin portion 60 on the package substrate sheet 50 by injection molding. The mold tool 70 includes an upper mold 71 used as a first mold, and a lower mold 72 used as a second mold and forming, along with the upper mold 71, a cavity 73 corresponding to a molding space. The lower mold 72 includes a molding surface 72a that is approximately entirely flat. The upper mold 71 includes a flat surface portion 71a corresponding to most of the molding surface and facing the molding surface 72a of the lower mold 72 parallel to the molding surface 72a.

The molding surface of the upper mold 71 is entirely covered by a sheet 61 including an elastic material. The sheet 61 is, for example, automatically fed from a feeding apparatus attached to the mold tool 70, and comes into close contact with the molding surface of the upper mold 71 by vacuum suction or the like. The sheet 61 is, for example, released from the molding surface of the upper mold 71 each time the mold tool 70 is opened and a molded article is removed from the mold tool, and the sheet 61 is fed for each shot of injection molding. The sheet 61 prevents a mold resin material 60M constituting the mold resin portion 60 from adhering to the molding surface of the upper mold 71. The sheet 61 has a thickness of, for example, approximately 200 μm.

The package substrate sheet 50 is set in the mold tool 70 as described above. As depicted in FIG. 7, the package substrate sheet 50 is set lying at a predetermined position on the molding surface 72a of the lower mold 72 of the mold tool 70. That is, the package substrate sheet 50 is set in the mold tool 70 with the cover glass 20 side corresponding to the upper mold 71 side and with the organic substrate sheet 10A side corresponding to the lower mold 72 side.

As depicted in FIG. 7, with the mold tool 70 closed, a cavity 73 is formed in the mold tool 70, with the mold resin material 60M injected into the cavity 73. With the mold tool 70 closed, the package substrate sheet 50 is sandwiched between the molding surface 72a of the lower mold 72 and the flat surface portion 71a of the molding surface of the upper mold 71 in the up-down direction. Consequently, with the mold tool 70 closed, the sheet 61 is pressed against and in close contact with the front surface 20a of the cover glass 20.

Additionally, the groove portion 21 of the cover glass 20 opens to the side surface 20c of the cover glass 20. Thus, with the mold tool 70 closed, the groove portion 21 is blocked by the sheet 61 from above and includes an internal space in communication with the inside of the cavity 73 through both ends of the groove portion 21 in the extension direction. A junction portion between the upper mold 71 and the lower mold 72 is provided with a gate 74 through which the mold resin material 60M is injected into the cavity 73.

With the mold closing step ended as described above and with the package substrate sheet 50 set in the mold tool 70, injection molding is performed to inject the mold resin material 60M into the cavity 73 to form the mold resin portion 60 around the image sensor 11 and the cover glass 20 on the organic substrate sheet 10A.

As depicted in FIG. 8, an injection step is executed to inject the mold resin portion 60 into the cavity 73 of the mold tool 70 via the gate 74 using an injection molding machine (not depicted). Accordingly, the cavity 73 is internally filled with the mold resin material 60M, and the mold resin material 60M covers the periphery of the image sensor 11 and the cover glass 20 on the upper surface of the organic substrate sheet 10A. Here, the groove portion 21 in the cover glass 20 is internally filled with the mold resin material 60M, with the internal space of the groove portion 21 in communication with the cavity 73. Note that, since the dam material 30 seals the portion between the image sensor 11 and the cover glass 20 as described above, the mold resin material 60M is prevented from infiltrating into the cavity 5.

In the step of forming the mold resin portion 60 by injection molding, the mold resin material 60M used is a black resin material containing a black pigment such as carbon black or titanium black to produce a light blocking effect. However, the mold resin material 60M is not limited to the material having the light blocking effect.

When the injection step ends, treatment for solidification such as heating or cooling is performed on the mold resin material 60M according to the material. Then, a removal step is executed to remove a molded article from the mold tool 70. Here, as depicted in FIG. 9, the molded article obtained is an organic substrate package 55 corresponding to a plate-like structure including the package substrate sheet 50 provided with the mold resin portion 60.

In the next step, the organic substrate package 55 is divided into multiple chips corresponding to the image sensors 11. The organic substrate package 55 is cut and divided into predetermined areas corresponding to the image sensors 11. Specifically, as depicted in FIG. 10, the organic substrate package 55 is divided using the dicer including the blade 75 corresponding to a disc-like grindstone. Note that the organic substrate package 55 may also be divided using the dicer including the blade 75 for forming the grooves 29.

Then, the blade 75 is rotated to dice the organic substrate package 55 along predetermined cutting lines 58 in the horizontal and vertical directions to cut and divide the organic substrate package 55 into pieces corresponding to the respective image sensors 11. This results in multiple package structures each including the cover glass 20 provided, via the dam material 30, on the image sensor 11 mounted on the organic substrate 10.

Then, multiple external connection terminals 40 are provided by applying a constant amount of solder ejected from a dispenser (not depicted) to terminals disposed in a grid on the bottom surface 10b of the organic substrate 10 to form semicircular solder balls based on surface tension of the solder. The steps as described above result in the solid-state imaging apparatus 1 as depicted in FIGS. 1 and 2.

In the solid-state imaging apparatus 1 according to the present embodiment and the method for manufacturing the solid-state imaging apparatus 1 as described above, the configuration is provided that includes the mold resin portion 60 formed around the image sensor 11 and the cover glass 20, and can prevent potential resin burrs of the mold resin on the front surface 20a of the cover glass 20 without the need for a dedicated mold. The reason for production of such an effect will be described using FIGS. 11 and 12. FIG. 11 is an explanatory diagram for the cover glass 20 provided with no groove portions 21. FIG. 12 is an enlarged view of a portion B1 of FIG. 8.

As depicted in FIG. 11, in the configuration provided with no groove portions 21 in the cover glass 20, pressure from the cover glass 20 fails to concentrate on the sheet 61, and pressurized injection of the mold resin material 60M causes the mold resin material 60M to infiltrate or permeate through the front surface 20a of the cover glass 20. A problem with this configuration is that resin burrs 60X are generated on the front surface 20a of the cover glass 20. When resin burrs 60X are generated on the front surface 20a of the cover glass 20 and are present in the light receiving area portion 23, light reception of the image sensor 11 may be seriously affected.

In contrast, according to the present embodiment, the solid-state imaging apparatus 1 produces effects as described below. During injection molding using the mold tool 70, in the mold closing state, the front surface 20a of the cover glass 20 is covered with the sheet 61 in close contact with the molding surface of the upper mold 71, as depicted in FIG. 12. Due to the mold closing force of the mold tool 70, the upper mold 71 brings the sheet 61 into pressure contact with the front surface 20a of the cover glass 20.

Here, the sheet 61 is elastic and has a thickness of approximately 200 μm, and thus the cover glass 20 penetrates into the sheet 61. Consequently, a portion of the sheet 61 covering the groove portion 21 in the cover glass 20 from above bulges relatively into the groove portion 21 to form a first bulging portion 66. Additionally, a portion of the sheet 61 outside the periphery of the front surface 20a of the cover glass 20 bulges relatively to form a second bulging portion 67.

In detail, as depicted in FIG. 12, the first bulging portion 66 is formed due to penetration, into the sheet 61, of corner portions 26 of the cover glass 20 formed between the front surface 20a and the inner side surface 21a of the groove portion 21. Additionally, the second bulging portion 67 is formed due to penetration, into the sheet 61, of a corner portion 27 of the cover glass 20 formed between the front surface 20a and the side surface 20c.

In this manner, the cover glass 20 is in close contact with the sheet 61 with the corner portions 26 of the groove portion 21 and the corner portion 27 of the periphery penetrating into the sheet 61. Such a state established allows the mold resin material 60M injected into the cavity 73 to be inhibited from infiltrating or permeating between the cover glass 20 and the sheet 61. The above-described effect can prevent potential resin burrs 60X of the mold resin material 60M on the front surface 20a of the cover glass 20.

As described above, the present technology improves the cover glass 20 side to prevent potential resin burrs. Thus, injection molding for forming the mold resin portion 60 can be performed using a general-purpose mold with a flat molding surface, such as the mold tool 70 including the upper mold 71 and the lower mold 72, without the need for a dedicated mold for prevention of potential resin burrs. This allows the need for investment to the mold to be eliminated or reduced, enabling resin burr measures to be performed inexpensively. Additionally, even with a change in the size or position of the cover glass 20 or a change in the layout on the organic substrate 10, there is no need to accordingly prepare a dedicated mold, enabling resin burr measures to be easily performed.

Additionally, in the solid-state imaging apparatus 1 of the present embodiment, the mold resin portion 60 includes the black resin material having the light blocking effect, and the groove portion 21 in the cover glass 20 is internally filled with the material forming the mold resin portion 60 to form the in-groove resin portion 62. In such a configuration, a light blocking portion can be provided by the groove portion 21 located above the outer periphery of the light receiving area 17 of the image sensor 11. This allows suppression of flare caused by light reflected from the dam material 30. Here, the flare refers to a phenomenon in which unwanted light is internally reflected to cause light fogging, whitening a part or all of an image. Specifically, the flare occurs as follows.

As depicted in FIG. 11, in the configuration provided with no groove portions 21 in the cover glass 20, a portion of light incident on the cover glass 20 is reflected by the dam material 30, and reflected light reaches the light receiving area 17 of the image sensor 11, as depicted by a light beam L1. The flare is caused by the reflected light from the dam material 30 reaching the light receiving area 17. In other words, a phenomenon occurs in which the light is reflected by the dam material 30 on an imaging section.

Additionally, to suppress the flare caused by reflected light from the dam material 30, some measures form the light blocking film 24 on the front surface 20a or the back surface 20b of the cover glass 20 by printing, vapor deposition, or the like, as depicted in FIG. 13. Accordingly, a light beam L2 to the dam material 30 can be blocked. However, such a measure requires an additional printing step or vapor deposition step or any other step for forming the light blocking film 24, increasing costs including a processing cost.

Thus, according to the solid-state imaging apparatus 1 of the present embodiment, as depicted in FIG. 14, the in-groove resin portion 62 in the groove portion 21 does not transmit light due to the black color of the in-groove resin portion 62, and thus functions as a light blocking portion. Accordingly, as depicted by a light beam L3, the in-groove resin portion 62 can block light attempting to enter the dam material 30 located below the groove portion 21. Consequently, incident light to the dam material 30 can be effectively blocked by optionally adjusting the position, width, depth, shape, or the like of the groove portion 21. That is, the light blocking function for the dam material 30 can be provided by forming a proper groove portion 21 in the cover glass 20 and providing the in-groove resin portion 62 in the groove portion 21.

As described above, according to the present embodiment, the solid-state imaging apparatus 1 can prevent the flare. In particular, the material for the dam material 30 is often a material likely to reflect light, and thus the configuration provided with the in-groove resin portion 62 in the groove portion 21 is effective for the flare caused by the reflected light from the dam material 30.

Additionally, in the solid-state imaging apparatus 1 of the present embodiment, the groove portion 21 in the cover glass 20 is formed inside the edge end of the cover glass 20 in such a manner as to leave the margin portion 20d in the peripheral portion of the front surface 20a of the cover glass 20. Such a configuration can effectively suppress potential resin burrs and possible flare.

For example, instead of the groove portions 21 formed in the cover glass 20, as depicted in FIG. 15, a step 28 of a predetermined depth may be formed in the peripheral portion outside a light receiving area of cover glass 20X to form a light blocking portion of the mold resin material 60M in the peripheral portion of the cover glass 20X. However, such a configuration poses a problem as described below.

Pressure is less likely to be concentrated on the sheet 61 of the cover glass 20 simply by providing the step 28 in the peripheral portion of the cover glass 20, as in the case with no step 28. Thus, during injection molding, the mold resin material 60M is likely to infiltrate or permeate through the front surface of the cover glass 20X. Accordingly, the configuration provided with the step 28 in the peripheral portion of the cover glass 20X is not sufficient as a measure for preventing potential resin burrs on the front surface of the cover glass 20X.

In contrast, in the solid-state imaging apparatus 1 of the present embodiment, the groove portion 21 is formed with the margin portion 20d left in the peripheral portion of the front surface 20a of the cover glass 20. Accordingly, pressure is likely to be concentrated on the sheet 61 to enable the cover glass 20 to penetrate into the sheet 61, thus allowing potential resin burrs to be suppressed. Additionally, even in a case where the in-groove resin portion 62 is provided in the groove portion 21 to constitute the light blocking portion, the light blocking portion can be partly provided near the light receiving area 17, thus enabling a sufficient strength of the cover glass 20 to be achieved.

<3. Configuration Example of Solid-state Imaging Apparatus according to Second Embodiment>

Now, in a second embodiment of the present disclosure, a configuration example of a solid-state imaging apparatus 1A will be described. As depicted in a plan view in FIG. 16, the solid-state imaging apparatus 1A according to the second embodiment differs from the solid-state imaging apparatus 1 according to the first embodiment in the manner of forming the groove portions 21 in the cover glass 20.

A plan view in FIG. 17A and a side view in FIG. 17B depict the cover glass 20 provided in the solid-state imaging apparatus 1A according to the second embodiment. As depicted in FIG. 17A, in regions outside the light receiving area portion 23 of the front surface 20a of the cover glass 20, two parallel inner groove portions 21Y are formed as the groove portions 21, in addition to outer groove portions 21X corresponding to the groove portions 21 similar to those in the first embodiment. All the groove portions 21 are each provided with the in-groove resin portion 62. Note that FIG. 17A is a plan view of the cover glass 20 and that FIG. 17B is a side view of the cover glass 20 (view from a direction indicated by arrow Z in FIG. 17A).

In a latitudinal direction of the cover glass 20 (up-down direction in FIG. 16) in plan view, the inner groove portion 21Y is formed at both positions outside the light receiving area portion 23 along a longitudinal direction of the cover glass 20 (lateral direction in FIG. 16). The two inner groove portions 21Y are provided along the edge portions of the light receiving area portion 23. The two inner groove portions 21Y each open to the side surface 20c of the cover glass 20 on both end sides. Note that the light receiving area portion 23 in the present embodiment is formed as a horizontally long area compared to the light receiving area portion 23 in the first embodiment.

As described above, the cover glass 20 includes multiple (two in the present embodiment) groove portions 21 along one of four sides of a rectangle corresponding to the shape of the cover glass 20 in plan view. That is, in the plan view depicted in FIG. 16, a total of six groove portions 21 are provided including the outer groove portions 21X extending along each of the horizontally opposite sides of the cover glass 20 and the two groove portions 21 extending along each of the vertically opposite sides of the cover glass 20, in other words, one outer groove portion 21X and one inner groove portion 21Y.

In the second embodiment, the two inner groove portions 21Y are formed. Accordingly, for example, in a case where the light receiving area 17 of the image sensor 11 has a large aspect ratio, the following effects are produced. That is, as depicted in FIG. 16, the four outer groove portions 21X mainly inhibit the mold resin material 60M having the light blocking effect from infiltrating through the front surface 20a of the cover glass 20, contributing to suppression of potential resin burrs. Additionally, the two outer groove portions 21X and the two inner groove portions 21Y along the edge portions of the light receiving area portion 23 of the cover glass 20 mainly function as a light blocking portion for the light receiving area 17, contributing to suppression of flare. As described above, each of the groove portions 21 can have a role, potential resin burrs can be prevented, and the light blocking effect can be improved.

Additionally, in the example described in the present embodiment, in the orientation depicted in FIG. 16, one groove portion 21 is formed along each vertical side of the cover glass 20, and two groove portions 21 are formed along each horizontal side of the cover glass 20. However, the number of groove portions is not particularly limited. For example, two groove portions 21 may be formed along each of the four sides of the cover glass 20, or two or more groove portions 21 may be formed without any problem. In other words, according to the present embodiment, the cover glass 20 may only need to include multiple groove portions 21 along at least one of four rectangular sides.

Additionally, more adjacent groove portions 21 may be provided, and the in-groove resin portion 62 may be provided in each of these groove portions. This allows the area of the light blocking portion to be extended. For example, in a configuration in which the in-groove resin portion 62 is used to cause one groove portion 21 to function as a light blocking portion, extension of the area of the light blocking portion requires the groove portion 21 to be engraved more deeply or formed like a band with a reduced depth and an increased width. This is not preferable in terms of the strength and cost of the cover glass 20. On the other hand, by providing more adjacent groove portions 21 as in the present embodiment, the area of the light blocking portion can be extended by simple processing without posing a problem as described above.

<4. Configuration Example of Solid-state Imaging Apparatus according to Third Embodiment>

Now, in a third embodiment of the present disclosure, a configuration example of a solid-state imaging apparatus 1B will be described. As depicted in a plan view in FIG. 18, the solid-state imaging apparatus 1B according to the third embodiment differs from the solid-state imaging apparatus 1 according to the first embodiment depicted in FIG. 1 in the manner of forming the groove portions 21 in the cover glass 20 and the configuration of the light blocking portion.

A plan view in FIG. 19A and a side cross-sectional view in FIG. 19B depict the cover glass 20 provided in the solid-state imaging apparatus 1B according to the third embodiment. Note that FIG. 19B is a cross-sectional view taken along line C-C in FIG. 19A. As depicted in FIG. 19A, in regions outside the area of the light receiving area portion 23 of the front surface 20a of the cover glass 20, the groove portion 21 includes one frame-like groove portion 21Z continuously extending and surrounding the light receiving area portion 23. The frame-like groove portion 21Z has a predetermined depth and is thus shaped generally like a semicircle in transverse cross-sectional view.

The frame-like groove portion 21Z is formed along the four sides of the cover glass 20 and includes four linear groove side portions 21c. Adjacent groove side portions 21c form a right-angle portion in plan view. The frame-like groove portion 21Z separates the front surface 20a of the cover glass 20 into a rectangular surface portion 20e corresponding to a portion inside the frame-like groove portion 21Z and a frame-like surface portion 20f corresponding to a portion outside the frame-like groove portion 21Z and extending along the external shape of the cover glass 20. As described above, the frame-like groove portion 21Z is shaped like a rectangle surrounding the outer periphery of the light receiving area portion 23, and is formed as a portion closed with respect to the side surfaces 20c of the cover glass 20.

The frame-like groove portion 21Z is formed by etching processing. However, the dicer including the blade 75 may be used to form the frame-like groove portion 21Z.

The frame-like groove portion 21Z is a portion closed with respect to the side surfaces 20c of the cover glass 20. In injection molding for forming the mold resin portion 60, the mold resin material 60M is prevented from infiltrating into the frame-like groove portion 21Z. Thus, to provide the frame-like groove portion 21Z with the light blocking function, the inner surface of the frame-like groove portion 21Z is provided with a light blocking film 35, as depicted in FIG. 19B.

The light blocking film 35 is formed to cover the entire inner surface of the frame-like groove portion 21Z. The light blocking film 35 is formed by applying a black resin, by ink jet, to a thickness at which the frame-like groove portion 21Z is not buried in the black resin.

As is the case with the first embodiment, in the injection molding for forming the mold resin portion 60, the frame-like groove portion 21Z of the present embodiment allows the cover glass 20 to penetrate into the sheet 61, and can suppress potential resin burrs on the front surface 20a of the cover glass 20. Additionally, by forming the light blocking film 35 on the inner surface of the frame-like groove portion 21Z, the light blocking portion can be provided around the light receiving area 17 of the image sensor 11, thus allowing suppression of flare caused by light reflected by the dam material 30.

In a variation of the present embodiment depicted in FIG. 20, a communication groove portion 22 is formed for the frame-like groove portion 21Z. The communication groove portion 22 is formed outside the frame-like groove portion 21Z, in other words, in the frame-like surface portion 20f of the front surface 20a. The communication groove portion 22 communicates with the inside of the frame-like groove portion 21Z on one end side and opens to the side surface 20c of the cover glass 20 on the other end side. Consequently, in the injection molding for forming the mold resin portion 60, the communication groove portion 22 forms a passage portion through which the molding space of the mold tool 70 is in communication with the inside of the frame-like groove portion 21Z.

In the example illustrated in FIG. 20, two communication groove portions 22 are respectively formed for a pair of facing groove side portions 21c of the frame-like groove portion 21Z, and communicate with a generally central portion of each groove side portion 21c. The communication groove portion 22, for example, has a small width compared to the frame-like groove portion 21Z.

The provision of the communication groove portions 22 enables the frame-like groove portion 21Z to be filled with the black mold resin material 60M by injection molding. That is, the communication groove portions 22 are passages for guiding the mold resin material 60M into the frame-like groove portion 21Z and discharging residual air in the frame-like groove portion 21Z. The mold resin material 60M in the frame-like groove portion 21Z becomes the in-groove resin portion 62, forming a black light blocking portion.

Note that the manner of forming the communication groove portions 22 is not limited to the example illustrated in FIG. 20 and that, needless to say, the communication groove portions 22 are provided at optimal positions according to the flow of the mold resin material 60M within the mold during the injection molding. In the configuration of the variation, the groove portion 21 can have a reduced overall length compared to the groove portion 21 in the first embodiment, allowing the amount of mold resin material 60M in the groove portion 21 to be saved.

Additionally, in the present embodiment, the configuration example has been described in which one frame-like groove portion 21Z surrounding the light receiving area portion 23 is provided. However, multiple frame-like groove portions 21Z surrounding the light receiving area portion 23 may be provided without any problem. In this case, the frame-like groove portions 21Z can be assigned respective roles with the outer frame-like groove portion 21Z mainly inhibiting infiltration of the mold resin material 60M and with the inner frame-like groove portion 21Z providing the light blocking function. Accordingly, potential burrs can be prevented, and the light blocking effect can be improved.

[Shape Examples of Cover Glass in Solid-state Imaging Apparatuses according to First to Third Embodiments]

Now, shape examples of the cover glass 20 in the solid-state imaging apparatuses 1 according to the first to third embodiments will be described. In the above-described embodiments, the transverse cross-sectional shape of the groove portion 21 is a general semicircle. However, the transverse cross-sectional shape of the groove portion 21 is not limited to the general semicircle. For example, the transverse cross-sectional shape of the groove portion 21 may be an inverted triangle (general V shape) 21S as depicted in FIG. 21A, may be a quadrangle 21T as depicted in FIG. 21B, or may be an inverted trapezoid 21U as depicted in FIG. 21C. In a case where the cross section is an inverted triangle, the light blocking film 35 is formed in the groove portion 21 by ink jet, or the groove portion 21 is filled with the black resin material having the light blocking effect, and the outer periphery of the light receiving area 17 is surrounded. Then, the light blocking film can block light entering at an incident angle smaller than the angle between an oblique side of the inner side surface 21a of the groove portion 21 and a perpendicular. Additionally, light entering at a larger incident angle is incident on a long side of the inverted triangle 21S and is reflected at the interface of the inner side surface 21a of the groove portion 21, reflected light travels to the outside of the light receiving area 17 of the image sensor 11, thus allowing potential flare to be prevented. This also applies to a case where the transverse cross-sectional shape of the groove portion 21 is the inverted trapezoid 21U.

Here, an example will be described in which the cross-sectional shape of the groove portion 21 depicted in FIG. 21A is the inverted triangle (general V shape) 21S and in which the light blocking effect is further improved. Specifically, the groove portion 21 is intended to block light incident on the dam material 30. The disclosure describing this below is intended not only to block light incident on the dam material 30 but also to prevent light incident on the cover glass 20 from being reflected at the boundary with the inner side surface 21a of the groove portion 21 and entering the image sensor 11.

Thus, by forming the cross section of the groove portion 21 like an inverted triangle (general V shape) and forming the inner side surface 21a at a predetermined angle $\Theta 3$, the apparatus can be configured to prevent light reflected from the inner side surface 21a from entering the image sensor 11. An example of the configuration will be described below.

FIG. 22 is a diagram illustrating refraction occurring when a light beam is incident on the cover glass 20. In FIG. 22, when being incident on the cover glass 20 at an incident angle $\Theta 1$, a light beam L6 is refracted at a refracting angle $\Theta 2$ and progresses into the cover glass 20. In other words, the light L6 incident at the incident angle $\Theta 1$ is refracted at the refracting angle $\Theta 2$ and progresses through the cover glass 20 at the angle $\Theta 2$.

Such a relation is expressed by $\sin\theta 1/\sin\theta 2 = n$ in accordance with the Snell's law. Note that n is a refractive index.

Here, a light beam L7 incident at the incident angle $\Theta 1$ of slightly smaller than 90° is similarly refracted at a refracting angle $\theta c$ and progresses into the cover glass 20. The refracting angle $\theta c$ in this case is referred to as a critical angle. Theoretically, the refracting angle $\theta 2$ at the incident angle $\theta 1$ of 90° corresponds to the critical angle $\theta c$. Consequently, the maximum value of the refracting angle $\theta 2$ corresponds to the critical angle $\theta c$. Accordingly, the angle at which, after entering the cover glass 20, the light beam L6 is refracted and progresses through the cover glass 20 is $\theta 2 \leq \theta c$. Note that $\sin 90° = 1$ and thus that the relational expression $n = 1/\sin\theta c$ is derived from the above-described expression.

However, actually, the solid-state imaging apparatus 1 is incorporated into an imaging apparatus such as a camera, and thus it is normally impossible that the incident angle $\Theta 1$ is 90°. FIG. 23 is a diagram illustrating the maximum value of a refracting angle of a light beam actually incident through a lens. In FIG. 23, a point P is a principle point of the lens (not depicted). A point A is an end of the groove portions 21 closer to the principle point P. A length M1 is a distance between the principle point P and the point A in the horizontal (principal plane) direction. A length M2 is a distance between the principal point P and the point A in the vertical (optical axis) direction.

Then, in FIG. 23, an incident angle $\theta 11$ of the light L6 incident on the point A from the principal point P corresponds to the maximum incident angle with respect to the cover glass 20 (hereinafter also referred to as the "maximum incident angle $\theta 11$"). Additionally, when the refracting angle at that time is designated as $\theta c1$, $\sin\theta 11/\sin\theta c1 = n$ is obtained, and

$$\theta c1 = \sin^{-1}(\sin\theta 11/n) \qquad (1)$$

is obtained.

On the other hand,

$$\theta 11 = \tan^{-1}(M1/M2) \qquad (2)$$

is obtained, and thus Equation (2) is substituted into Equation (1) to determine

$$\theta c1 = \sin^{-1}\sin[\{\tan^{-1}(M1/M2)\}/n] \qquad (3).$$

$\theta c1$ is smaller than the critical angle $\theta c$, and

$$\theta c1 \leq \theta c \qquad (4)$$

is obtained.

That is, the maximum incident angle $\theta 11$ on the cover glass 20 via the lens is expressed by Equation (2). Then, the refracting angle $\theta c1$ at that time corresponds to the maximum refracting angle (hereinafter also referred to as the "maximum refracting angle $\theta c1$"), and the value of the refracting angle is expressed by Equation (1) or Equation (3).

Now, the relation between the incident angle L6, an angle $\Theta 3$ between the inner side surface 21a of the groove portion 21 and a perpendicular, and the maximum refracting angle $\theta c1$ will be described with reference to FIGS. 24 to 27.

In a case of $\theta 3 \geq \theta c1$, as depicted in FIG. 24, the incident light L6 incident at the maximum incident angle $\theta 11$ is refracted at the point A on the cover glass 20 at the maximum refracting angle $\theta c1$, and progresses through the cover glass 20. Then, at the back surface of the cover glass 20, the light is refracted at the same angle as the maximum incident angle $\theta 11$ in a direction away from the principal point P in the horizontal (principal plane) direction. In this case, as depicted in FIG. 24, refracted light is not radiated into the light receiving area 17 of the image sensor 11.

Then, as depicted in FIG. 25, in a case of $\theta 3 < \theta c1$ and in a case where the angle $\theta 3$ is not very small, incident light L7 is incident at an incident angle $\theta 12$ and is refracted at an angle $\theta c2$ that is slightly smaller than the maximum refracting angle $\theta c1$ on the front surface 20a of the cover glass 20, and progresses through the cover glass 20. Then, the light impinges on the inner side surface 21a of the groove portion 21 and is reflected from the inner side surface 21a, and the light is refracted at the back surface of the cover glass 20 and exits the cover glass 20 in a direction away from the principal point P in the horizontal (principal plane) direction. In this case, as depicted in FIG. 25, the refracted light is not radiated into the light receiving area 17 of the image sensor 11.

Now, the maximum value of the angle $\theta 3$ will be described at which the incident light L7 is not radiated into the light receiving area 17 of the image sensor 11 even when the incident light L7 impinges on the inner side surface 21a of the groove portion 21 and is reflected from the inner side surface 21a.

The minimum value of the angle $\theta 3$ as described above is $\theta 3 < \theta c1$, and further the light impinging on the inner side surface 21a of the groove portion 21 is reflected from the inner side surface 21a and proceeds downward in the vertical direction.

Specifically, as depicted in FIG. 26, when being incident on the front surface of the cover glass 20 at the incident angle $\theta 12$, the incident light L7 is refracted at the refracting angle $\theta c2$, and proceeds through the cover glass 20. When impinging on the inner side surface 21a of the groove portion 21, the incident light L7 is reflected from the inner side surface 21a. Then, the incident light L7 progresses through the cover glass 20 downward in the vertical direction, and at the back surface of the cover glass 20, the incident light L7 exits the cover glass 20 and travels straight at the refracting angle of 0°. The angle $\Theta 3$ between the inner side surface 21a of the groove portion 21 and the perpendicular corresponds to the minimum value at which the refracted light is not radiated into the light receiving area 17 of the image sensor 11.

Thus, the minimum value of the angle $\Theta 3$ between the inner side surface 21a of the groove portion 21 and the perpendicular is determined at which the refracted light in FIG. 26 is not radiated to the image sensor 11.

FIG. 27 is an enlarged view of a portion in which the incident light L7 depicted in FIG. 26 is incident on the front surface 20a of the cover glass 20 at the incident angle $\Theta 12$. FIG. 27 depicts, with a dashed line, a virtual route of the incident light L6 formed in a case where the incident light L6 is incident on the cover glass 20 at the point A. In this case, the incident light L6 is refracted at the point A at the maximum refracting angle $\theta c1$ and progresses through the virtual route depicted with a dashed line. Here, when being incident on the point B at the incident angle $\Theta 12$, the incident light L7 is refracted at the refracting angle $\theta c2$. Then, the incident light L7 progresses through the cover glass 20, and impinges on the inner side surface 21a of the groove portion 21 and is reflected from the inner side surface 21a. The incident light L7 then travels through the cover glass 20 downward in the vertical direction. Then, the incident light L7 exits the back surface of the cover glass 20 at a refracting angle of 0° and travels straight.

Here, in FIG. 27, a straight line ACE corresponds to the inner side surface 21a of the groove portion 21. Accordingly, in $\triangle ACD$, $\angle CAD = \Theta 3$ is obtained. Additionally, $\angle ECF = \Theta 3$ is obtained. This is because both angles are between the light and the perpendicular. Then, LACD = $\Theta 3$ is obtained. This is because the incident angle is equal to the reflection angle.

Additionally, LADB = $\theta c2$ is obtained. Consequently, $\angle ADC = \pi - 2 \times \Theta 3$ is obtained. However, the sum of $\angle ADB$ and LADC is n, and thus LADB + LADC = $\pi - (2 \times \theta 3) + \theta c2 = \pi$ is obtained.

Finally, $\theta c2 = 2 \times \theta 3$ holds true. Consequently, the angle $\theta 3$ is determined as

$$\text{Consequently, the angle } \theta 3 \text{ is determined as } \theta 3 = (\theta c2)/2 \quad (5).$$

Here, as the point A is moved closer to the point B, the point C is increasingly moved closer toward the point A.

As a result, the refracting angle $\theta c2$ matches the maximum refracting angle $\theta c1$, and

$$\theta 3 = (\theta c1)/2 \quad (6)$$

is obtained.

That is, it is sufficient if the minimum value of the angle $\Theta 3$ is half the maximum refracting angle $\theta c1$.

In conclusion, the angle $\Theta 3$ between the inner side surface 21a of the groove portion 21 and the perpendicular is obtained as follows:

$$\theta 3 > (\theta c1)/2 \quad (7).$$

Additionally, Equation (3) is substituted into Equation (7) to determine:

$$\theta 3 > (\theta c1)/2 = \sin^{-1}\sin[\{\tan^{-1}(M1/M2)\}/n]/2 \quad (8).$$

The use of Equation (8) allows determination of the minimum value of the angle $\Theta 3$ between the inner side surface 21a of the groove portion 21 and the perpendicular.

On the other hand, the maximum value of the angle $\Theta 3$ corresponds to the angle at which no burrs are generated when a mold resin is injected, and only needs to be determined optionally.

As described above, the cross section of the groove portion 21 in the cover glass 20 is formed like an inverted triangle (general V shape), and the angle $\theta 3$ between the inner side surface 21a of the groove portion 21 and the perpendicular is formed in such a manner that $\theta 3 > (\theta c1)/2$. This allows the incident light L6 to be prevented from being reflected from the inner side surface 21a of the groove portion 21 of the cover glass 20 and entering the image sensor 11. The groove portion 21 shaped like an inverted triangular can be formed by using the blade 75 with a cutting edge having the angle $\theta 3$ on each of the right and left sides. That is, the groove portion 21 satisfying Equation (8) according to the present disclosure can be manufactured by the manufacturing method described above with reference to FIGS. 4 to 10, and requires no new manufacturing method. Note that the groove portion 21 formed like an inverted triangle (general V shape) has been described but that the above description also applies to the groove portion 21 formed like an inverted trapezoid as depicted in FIG. 21C. Additionally, the above description also applies to cases in FIGS. 28 and 29.

Here, an increased angle $\Theta 3$ between the inner side surface 21a and the perpendicular may weaken penetration contact of the sheet 61 with the groove portion 21. In such a case, the cross-sectional shape of the groove portion 21 may be formed as depicted in FIG. 28. That is, as depicted in FIG. 28, the inner side surfaces 21a are formed generally like a V shape in the groove portion 21, and upper ends of the inner side surfaces 21a are formed to extend slightly and perpendicularly as penetration surfaces 21g, 21g, thus allowing the penetration contact of the sheet 61 with the groove portion 21. In this case, the angle $\theta 3$ between the inner side surface 21a and the perpendicular needs to satisfy $\theta 3 > (\theta c1)/2$.

Additionally, the cross-sectional shape of the groove portion 21 may be formed as depicted in FIG. 29. That is, the groove portion 21 depicted in FIG. 29 is formed by dividing the groove portion 21 generally V shaped as depicted in FIG. 28 into two pieces in the lateral direction, and has the shape of the left piece resulting from the dual division. Needless to say, the opposite other groove portion 21 has the shape of the right piece resulting from the dual division. Specifically, a quadrangle like a horizontal trapezoid is formed using a first penetration surface 21g corresponding to a vertical surface, the inner side surface 21a forming an inclined surface extending from the first penetration surface 21g, and a second penetration surface 21h formed extending vertically from a lower end of the inner side surface 21a. Such formation allows the penetration contact of the sheet 61 with the groove portion 21 to be improved.

<5. Configuration Example of Solid-state Imaging Apparatus according to Fourth Embodiment>

Now, a configuration example of a solid-state imaging apparatus 1C according to a fourth embodiment of the present disclosure will be described. FIG. 30 is a plan view of the solid-state imaging apparatus 1C. Additionally, FIG. 31 is a cross-sectional view taken along line Y-Y in FIG. 30. The fourth embodiment of the solid-state imaging apparatus 1 differs from the first embodiment of the solid-state imaging apparatus 1 in the positions where groove portions 21A and 21B are engraved in the cover glass 20. That is, in the first embodiment, the groove portion 21 is engraved in the front surface 20a of the cover glass 20, whereas in the fourth embodiment, the groove portion 21 is engraved opening to the side surfaces 20c on the four sides of the cover glass 20 and surrounds the outer periphery of the light receiving area 17 of the image sensor 11.

The side surfaces 20c on four sides of the cover glass 20 in the present embodiment are provided with groove portions 21A opening in a front-rear direction outside the light receiving area portion 23 corresponding to the light receiving area 17 of the image sensor 11, and groove portions 21B opening in the lateral direction as depicted in FIGS. 30 and 31. Additionally, the cover glass 20 is configured as depicted in a plan view in FIG. 32A and a side view in FIG. 32B (view from a Y direction indicated by an arrow in FIG. 32A).

Specifically, as depicted in FIGS. 30 and 32, the groove portions 21A and the groove portions 21B are engraved in the respective side surfaces 20c of the cover glass 20 all along the periphery outside the light receiving area portion 23 of the cover glass 20 shaped like a rectangle in plan view in such a manner that the light receiving area portion 23 is left inward with respect to each side surface 20C of the cover glass 20. Thus, the groove portions 21A and the groove portions 21B (when hereinafter collectively expressed, the four groove portions are referred to as the "groove portion 21.") are formed all over the region outside the area of the light receiving area portion 23 corresponding to a projection area of the light receiving area 17 of the image sensor 11 in plan view, and open to the side surfaces 20c on the four sides in the front-rear direction and the lateral direction.

As depicted in FIG. 32B, in each of the groove portions 21 in the cover glass 20, the inner side surfaces 21a are formed parallel to each other with a certain width W in a thickness direction in transverse cross-sectional view, and a bottom surface 21b of the groove portion 21 is formed extending orthogonally to the inner side surfaces 21a and is shaped generally like a flat surface. The groove portion 21A has a certain depth D3 in the front-rear direction, and the groove portion 21B has a certain depth D4 in the lateral direction. In particular, the groove portion 21 includes the inner side surfaces 21a parallel and opposite to each other in transverse cross-sectional view and the bottom surface 21b extending orthogonally to the inner side surfaces 21a and shaped generally like a flat surface, and the cross-sectional shape of the groove portion 21 is like a laterally symmetric rectangle as depicted in FIG. 32B.

The depths D3 and D4 of the groove portion 21 are enough to reach the area of the light receiving area portion 23 of the cover glass 20. Here, the depths D3 and D4 of the groove portion 21 are each a dimension from the side surface 20c of the cover glass 20 to the bottom surface 21b of the groove portion 21 in the depth direction.

As depicted in FIG. 31, the groove portion 21 is internally filled with the mold resin material 60M corresponding to the material forming the mold resin portion 60, forming the in-groove resin portion 62. Consequently, the in-groove resin portion 62 is formed to follow the shape of the groove portion 21 and the cover glass 20 and is in communication with the mold resin portion 60. Additionally, the in-groove resin portion 62 includes a groove contact surface 62a extending along the inner side surfaces 21a and the bottom surface 21b forming the groove portion 21. Otherwise, the configuration of the fourth embodiment is similar to the configuration of the first embodiment, and the description thereof is omitted.

Note that, as an example only, the cover glass 20 has a thickness of from approximately 400 to 500 $\mu$m. The groove portions 21A and 21B have a width of from approximately 100 to 250 $\mu$m. The groove portions 21A and 21B may be determined to have any widths from the external dimensions of the cover glass 20 and the dimensions of the light receiving area portion 23. Additionally, in a case where the solid-state imaging apparatus 1C and the light receiving area 17 are both square in plan view, the dimension D3 and the depth D4 can be the same dimensions.

In the solid-state imaging apparatus 1C of the present embodiment, the mold resin portion 60 includes a black resin material having a light blocking effect. Consequently, the in-groove resin portion 62 with which the groove portion 21 in the cover glass 20 is internally filled forms the light blocking film 24. This configuration locates the groove portion 21 closer to the area above the outer periphery of the light receiving area 17 of the image sensor 11 than the front surface 20a of the cover glass 20. Consequently, forming the groove portion 21 of the present embodiment allows the light blocking film 24 to be formed closer to the light receiving area 17.

That is, according to the solid-state imaging apparatus 1C of the present embodiment, the in-groove resin portion 62 in the groove portion 21 is formed in black as depicted in FIG. 33, and thus does not transmit light and functions as a light blocking portion. Thus, as depicted by a light beam L4, light traveling to enter the dam material 30 located below the groove portion 21 can be blocked by the in-groove resin portion 62. Consequently, by optionally adjusting the position, width, depth, shape, and the like of the groove portion 21, light incident on the dam material 30 can be effectively blocked. Accordingly, by forming the proper groove portion 21 within the range of the area of the light receiving area portion 23 through the side surface 20c of the cover glass 20 and providing the in-groove resin portion 62 in the groove portion 21, the dam material 30 can be provided with a light blocking function. Thus, flare caused by light reflected by the dam material 30 can be suppressed.

As described above, according to the solid-state imaging apparatus 1C of the present embodiment, the light blocking portion can be formed at a position in the groove portion 21 closer to the portion of the front surface 20a of the cover glass 20 located above the outer periphery of the light receiving area 17 of the image sensor 11. Consequently, the preventive effect against flare can be improved. In particular, the material of the dam material 30 is often likely to reflect light, and thus the in-groove resin portion 62 provided in the groove portion 21 is effective against flare caused by reflected light from the dam material 30.

Additionally, the grooves 29 respectively engraved opening to the side surfaces 20c on the four sides of the cover glass 20 are in communication with the space in which the mold resin portion 60 is formed. Thus, the mold resin material 60M with which the groove portion is filled by injection molding flows into the groove 29 opening to the side surface 20c of the cover glass 20. Then, the sheet 61 covering the entire front surface 20a of the cover glass 20 is sucked by the flow of the mold resin material 60M and penetrates into and comes into close contact with the corner portion 27 formed by the front surface 20a and the side surface 20c of the cover glass 20. This allows the mold resin material 60M to be inhibited from being infiltrating or permeating through the junction surface between the cover glass 20 and the sheet 61, allowing potential resin burrs on the front surface 20a of the cover glass 20 to be prevented.

Additionally, by forming an acute angle between the front surface 20a and the side surface 20c of the cover glass 20, that is, by providing the corner portion 27 with an acute angle, the sheet 61 penetrates into the corner portion 27, allowing the contact between the sheet 61 and the front surface 20a of the cover glass 20 to be made closer. This allows potential resin burrs on the front surface 20a of the cover glass 20 to be further prevented.

Note that it is sufficient if the groove portion 21 is formed on the four sides of the cover glass 20 in the front-rear direction and the lateral direction and that walls may be appropriately formed that couple the inner side surfaces 21a in the up-down direction in order to reinforce the groove portion 21.

<6. Method for Manufacturing Solid-state Imaging Apparatus according to Fourth Embodiment>

[Basic Form of Method for Manufacturing Solid-State Imaging Apparatus according to Fourth Embodiment]

Now, a basic form of a method for manufacturing the solid-state imaging apparatus 1C according to the fourth embodiment will be described on the basis of the drawings. FIG. 34 is an explanatory diagram of the step of processing the cover glass 20 in the basic form of the method for manufacturing the solid-state imaging apparatus 1C.

In the method for manufacturing the solid-state imaging apparatus 1C, first, a step is executed in which the cover glass 20 is prepared as a member covering the front surface 11a side of the image sensor 11.

In the step of preparing the cover glass 20, the rectangular glass panel 20A with a predetermined dimension is prepared that is similar to that described with reference to FIG. 4 and that is used as the material of the cover glass 20. The cover glass 20 is obtained by cutting the glass panel 20A with a large size into pieces each with a predetermined size. In other words, the cover glass 20 is obtained by cutting and dividing the glass panel 20A into rectangular pieces.

Thus, the glass panel 20A is cut and divided into pieces of the cover glass 20 using an apparatus referred to as a dicer and including a blade 75 similar to that described with reference to FIG. 4.

Then, in the cover glass 20 resulting from the division, the grooves 29B are formed in both side surfaces 20c in the lateral direction, and the grooves 29A are formed in both side surfaces 20c in the front-rear direction, the grooves 29B and the grooves 29A forming the groove portion 21. The grooves 29A and 29B are formed in the cover glass 20 using a dicer including the blade 75 for dicing as depicted in FIG. 34. The grooves 29A and 29B are formed by adjusting the depth position of the blade 75 with respect to the side surface 20c of the cover glass 20 and using the blade 75 rotating to linearly cutting a part of the side surface 20c of the cover glass 20 to a predetermined depth.

Specifically, as depicted in FIG. 34B, the blade 75, while being rotated (see arrow A1), is moved in the horizontal direction (rightward in FIG. 34B) (see arrow A2) to engrave the groove 29A in the upper side surface 20c in the horizontal direction to a predetermined depth D3. Once engraving of the groove 29A in the horizontal direction ends, the direction of the blade 75 is rotated 90° rightward and moved in the vertical direction (downward in FIG. 34B) to engrave the groove 29B in the right side surface 20c in the vertical direction to a predetermined depth D4.

Then, a similar operation is performed to engrave the groove 29A in the lower side surface 20c in the horizontal direction (leftward in FIG. 34B) to the predetermined depth D3, and then to engrave the groove 29B in the left side surface 20c in the vertical direction (upward in FIG. 34B) to the predetermined depth D4. Thus, the grooves 29A and 29B are formed in the side surfaces 20c of the cover glass 20 in the front-rear direction and the lateral direction. The depths of the grooves 29A and 29B are defined by adjusting the depth of the blade 75 according to a distance relation between the side surface 20c of the cover glass 20 and the light receiving area portion 23. Additionally, the dicer may be the same as or different from that used in the step of dividing the glass panel 20A. In addition, the blade 75 may be replaced with another blade with an appropriate shape.

Note that, in the step of forming the grooves 29A and 29B in the above-described cover glass 20, the method for moving the blade has been described but that in an alternative configuration, with the position of the blade 75 fixed, the cover glass 20 may be moved to engrave the grooves 29A and 29B. For example, in an alternative configuration, a jig (not depicted) may be used to grip the cover glass 20, bring the side surface 20c of the cover glass 20 into contact with the cutting edge of the blade 75, and move the cover glass 20 parallel, while forming the grooves 29A and 29B to the predetermined depths D3 and D4. That is, the following method is possible. Once the groove 29A or 29B is engraved in one side surface 20c, the cover glass 20 is rotated 90°, and the groove 29 or the groove 29B is engraved in the next side surface 20c. The cover glass 20 is sequentially rotated 90° each time engraving ends, and the groove 29A or the 29B is engraved in all the side surfaces 20c.

Additionally, the side surface 20c may be inclined toward the groove portion 21 side, and an acute angle may be formed between the front surface 20a and the side surface 20c of the cover glass 20, that is, the corner portion 27 formed by the front surface 20a and the side surface 20c may be provided with an acute angle. This enables the penetration contact of the sheet 61 with the front surface 20a of the cover glass 20 to be further improved, allowing potential resin burrs on the front surface 20a of the cover glass 20 to be prevented.

The step of preparing the cover glass 20 is executed as described above.

Next, the following processing is substantially similar to that described above from the step in FIG. 6 to the step of dividing the organic substrate package 55 depicted in FIG. 10 except that the groove portions 21 in the cover glass 20 open to the respective side surfaces 20c on the four sides of the cover glass 20 and that the in-groove resin portion 62 is in communication with the mold resin portion 60, and the description of the processing is omitted.

[Variation 1 of Method for Manufacturing Solid-state Imaging Apparatus according to Fourth Embodiment]

Variation 1 of the method for manufacturing the solid-state imaging apparatus 1C according to the fourth embodiment will be described on the basis of the drawings. FIGS. 35 and 36 are explanatory diagrams of the step of processing the cover glass 20 in Variation 1 of the method for manufacturing the solid-state imaging apparatus 1C according to the fourth embodiment. Variation 1 differs from the basic form in that the cover glass 20 is formed by laminating and bonding three pieces of glass resulting from division and including a large piece (cover glass 20U), a medium piece (cover glass 20M), and a large piece (cover glass 20L) together in this order.

In Variation 1 of the method for manufacturing the solid-state imaging apparatus 1C, first, a step is executed in which the cover glass 20 is prepared as a member covering the front surface 11a side of the image sensor 11.

In the step of preparing the cover glass 20, first, as described for another step with reference to FIG. 4, the cover glass 20U, the cover glass 20M, and the cover glass 20L are prepared that are obtained by cutting and dividing, into rectangular pieces, the glass panel 20A that is thinner than that used in the basic form of the present embodiment.

The cover glass 20U forms the front surface 20a of the cover glass 20 and the upper inner side surface 21a of the groove portion 21. The shape of the cover glass 20U in plan view is identical to that of the cover glass 20. In this configuration, the cover glass 20M is smaller than the cover glass 20U and the cover glass 20L and slightly larger than the area of the light receiving area portion 23 of the cover glass 20 in plan view. That is, in this configuration, the cover glass 20 is smaller by a dimension of a depth D3 × 2 in the front-rear direction and by a dimension of a depth D4 × 2 in the lateral direction. The cover glass 20M forms the bottom surface 21b of the groove portion 21 on a peripheral side surface of the cover glass 20M. The cover glass 20L forms the lower inner side surface 21a and the back surface 20b of the cover glass 20, and the shape of the cover glass 20L in plan view is identical to that of the cover glass 20U.

Additionally, the thickness of the three pieces of the cover glass 20U, 20M, and 20L laminated on one another is desirably the same as that of the cover glass 20 in the basic form of the present embodiment. For example, each of the cover glass 20U, the cover glass 20M, and the cover glass 20L may have a thickness that is one-third of the thickness of the cover glass 20, or the cover glass 20M may have a slightly smaller thickness than the other pieces of cover glass. The ratio of the thicknesses only needs to be appropriately determined according to the structure and shape of the package of the solid-state imaging apparatus 1C.

Then, as depicted in a side view in FIG. 36A, the cover glass 20U, the cover glass 20M, and the cover glass 20L are laminated together in this order in the vertical direction and bonded together. Thus, in the cover glass 20, as depicted in FIGS. 36A and 36B, the grooves 29A and 29B respectively opening to the side surfaces 20c on the four sides of the cover glass 20 can be formed all along the peripheral region outside the light receiving area portion 23 on the front surface 20a side.

This configuration eliminates the step of engraving the grooves 29A and 29B all along the periphery of the side surfaces 20c of the cover glass 20, and still allows the grooves 29A and 29B to be reliably formed. The grooves 29A and 29B are filled with the black mold resin material 60M having the light blocking effect to form the light blocking film 24.

The other steps are similar to those in the basic form of the method for manufacturing the solid-state imaging apparatus 1C according to the present embodiment, and thus the description of the steps is omitted.

[Variation 2 of Method for Manufacturing Solid-state Imaging Apparatus according to Fourth Embodiment]

Variation 2 of the method for manufacturing the solid-state imaging apparatus 1C according to the fourth embodiment will be described on the basis of the drawings. FIGS. 37 to 39 are explanatory diagrams of the step of processing the cover glass 20 in Variation 2 of the method for manufacturing the solid-state imaging apparatus 1C. Variation 2 differs from the basic form in that the cover glass 20 is formed by cutting off the periphery of the cover glass 20L resulting from division to form the lower inner side surface 21a and the bottom surface 21b of the groove portion 21 and laminating the cover glass 20L on the resultant cover glass 20L.

In Variation 2 of the method for manufacturing the solid-state imaging apparatus 1C, first, a step is executed in which the cover glass 20 is prepared as a member covering the front surface 11a side of the image sensor 11.

In the step of preparing the cover glass 20, first, as described for another step with reference to FIG. 4, the cover glass 20U and the cover glass 20L are prepared that are obtained by cutting and dividing the glass panel 20A into rectangular pieces. The cover glass 20U forms the front surface 20a of the cover glass 20 and the upper inner side surface 21a of the groove portion 21, and the shape of the cover glass 20L in plan view is identical to that of the cover glass 20. The cover glass 20L forms the lower inner side surface 21a and the bottom surface 21b of the groove portion 21 of the cover glass 20 and also forms the back surface 20b of the cover glass 20, and the shape of the cover glass 20L in plan view is identical to that of the cover glass 20. Consequently, the cover glass 20U and the cover glass 20L are identical in plan view.

First, as depicted in a side view in FIG. 37, the cover glass 20L is prepared. Then, the dicer including the blade 75 is used to cut off the periphery of the cover glass 20L. That is, the periphery in the front-rear direction is cut off by the dimension of the width D3, and the periphery in the lateral direction is cut off by the dimension of the width D4.

Thus, in the cover glass 20L, as depicted in a side view in FIG. 38, the lower inner side surface 21a and the bottom surface 21b of the groove portion 21 of the cover glass 20 are formed all along the peripheral region outside the light receiving area portion 23 on the front surface 20La side. Preparation of the cover glass 20L is complete as described above.

[Variation 3 of Method for Manufacturing Solid-state Imaging Apparatus according to Fourth Embodiment]

Additionally, the step of cutting off the periphery of the cover glass 20L may be executed directly on the glass panel 20A before division rather than on rectangular pieces of the glass panel 20A resulting from the division as described above.

Specifically, the glass panel 20A is prepared first.

Then, as depicted in FIGS. 40A and 40B, the dicer including the blade 75 is used to cut off portions of the glass panel 20A (grooves 29C, 29D, 29E, and 29F in FIG. 40B) other than a portion corresponding to the front surface 20La of the cover glass 20L, in the horizontal direction and the vertical direction. In this case, the width D3 of the groove 29C to be removed from the peripheral portion of the glass panel 20A corresponds to the depth D3 corresponding to the dimension of the inner side surface 21a of the groove portion 21A. Additionally, the width D5 of the groove 29D to be removed from between the front surfaces 20La of the glass panels 20A adjacent to each other in the front-rear direction as viewed in FIG. 40B equals twice the width D3 of the groove 29C plus a cutting margin used for cutting with cutting lines 25.

Consequently, cutting and division with the cutting lines 25 similarly lead to the depth D3 of the groove 29D corresponding to the dimension of the inner side surface 21a of the groove portion 21A.

Additionally, the width D4 of the groove 29E to be removed from the peripheral portion of the glass panel 20A corresponds to the depth D4 corresponding to the dimension of the inner side surface 21a of the groove portion 21B. Additionally, the width D6 of the groove 29F to be removed from between the front surfaces 20La of the glass panels 20A adjacent to each other in the lateral direction as viewed in FIGS. 40A and 40B equals twice the width D4 of the groove 29E plus a cutting margin used for cutting with cutting lines 25.

Consequently, cutting and division with the cutting lines 25 similarly lead to the depth D4 of the groove 29F corresponding to the dimension of the inner side surface 21a of the groove portion 21B.

Additionally, as depicted in FIG. 40A, the depth D7 to be cut off corresponds to the dimension of the bottom surface 21b of the groove portion 21 in the thickness direction.

Then, the dicer including the blade 75 is used to cut and divide the glass panel 20A at the positions of the cutting lines 25. Thus, the cover glass 20L is obtained that is provided with the lower inner side surface 21a and the bottom surface 21b of the groove portion 21 in the peripheral portion of the cover glass 20L. In this case, division forms each of the groove 29C in the peripheral portion and the groove 29D resulting from dual division into the groove 29A, and forms each of the groove 29E in the peripheral portion and the groove 29F resulting from dual division into the groove 29B.

As depicted in a side view in FIG. 39, the cover glass 20U is laminated on and bonded to the front surface 20La of the cover glass 20L. Thus, the groove portions 21A and 21B can be formed that open to the side surfaces 20c on the four sides of the cover glass 20.

This configuration allows the grooves 21A and 21B to be engraved together, eliminating the need for engraving the grooves 29A and 29B all along the periphery of the side surfaces 20c of each piece of the cover glass 20. Furthermore, the grooves 29A and 29B respectively opening to the side surfaces 20c on the four sides of the cover glass 20 can be reliably formed all along the peripheral portion outside the light receiving area portion 23 on the front surface 20a side. The grooves 29A and 29B are filled with the black mold resin material 60M having the light blocking effect to form the light blocking film 24.

The other steps are similar to those in the basic form of the method for manufacturing the solid-state imaging apparatus 1C according to the present embodiment, and thus the description of the steps is omitted.

Note that the thickness of the cover glass 20U and the cover glass 20L laminated on each other is desirably the same as that of the cover glass 20 in the basic form of the present embodiment. For example, the cover glass 20U and the cover glass 20L may each have a thickness that is one-third or two-thirds of the thickness of the cover glass 20. The ratio of the thicknesses only needs to be appropriately determined according to the structure and shape of the package of the solid-state imaging apparatus 1C.

[Shape Example of Cover Glass in Solid-state Imaging Apparatus according to Fourth Embodiment]

Note that, in the present embodiment described above, the groove portion 21 of the cover glass 20 has a generally rectangular cross-sectional shape but that the cross-sectional shape of the groove portion 21 is not limited to the generally rectangular shape. The bottom surface 10b of the groove portion 21 may have, for example, a generally semicircular cross-sectional shape as depicted in FIG. 41 or an inverted trapezoidal cross-sectional shape as depicted in FIG. 42. This formation allows stress concentrated on the junction portion between the bottom surface 21b and the inner side surface 21a to be alleviated. Then, the groove portion 21 depicted in FIGS. 41 and 42 is internally filled with the black mold resin material 60M, and the in-groove resin portion 62 forms the light blocking film 24.

Additionally, the cross-sectional shape may be an inverted triangle (general V shape) as depicted in FIG. 43, a right triangle as depicted in FIG. 44, or a vertically inverted right triangle as depicted in FIG. 45. In these cases, the groove portion 21 is internally filled with the black mold resin material 60M to form the light blocking film 24, allowing the light blocking film 24 to block light entering at an incident angle smaller than an apex angle. Additionally, even in a case where light entering at a larger incident angle is incident on a long side of an inverted triangle and is reflected at an interface of the groove portion 21, the reflected light is reflected to the outside of a light receiving portion of the image sensor 11. This allows potential flare to be prevented. This also applies to a case where the transverse cross-sectional shape of the groove portion 21 is an inverted trapezoid.

<7. Configuration Example of Solid-state Imaging Apparatus according to Fifth Embodiment>

Now, a configuration example of a solid-state imaging apparatus 1D according to a fifth embodiment will be described. The solid-state imaging apparatus 1D according to the fifth embodiment differs from the solid-state imaging apparatus 1 according to the first embodiment in that, in the fifth embodiment, the back surface 20b of the cover glass 20 is provided with the groove portion 21D.

FIG. 46 is a plan view of the solid-state imaging apparatus according to the fifth embodiment. Additionally, FIG. 47 is a cross-sectional view taken along line D-D in FIG. 46. The solid-state imaging apparatus 1D according to the present embodiment uses the cover glass 20 in FIG. 48 and is provided with the groove portions 21 in the front surface 20a of the cover glass 20 and the groove portions 21D in the back surface 20b as depicted in FIGS. 46 and 47.

That is, in the first embodiment, as depicted in FIGS. 1 and 2, the groove portions 21 are formed only in the front surface 20a of the cover glass 20. In contrast, in the fifth embodiment, the front surface 20a of the cover glass 20 is provided with the groove portions 21, the back surface 20b is provided with the groove portions 21D, and the groove portions 21 and the groove portions 21D surround the outer periphery of the light receiving area portion 23 corresponding to the light receiving area 17 of the image sensor 11, as depicted in FIGS. 46, 47, and 48.

The groove portion 21 and the groove portion 21D in the present embodiment will be described in further detail. The groove portions 21 formed in the front surface 20a of the cover glass 20 are provided outside the light receiving area 17 of the image sensor 11, match the external shape of the image sensor 11 in a plan view, and are provided parallel to each other at a predetermined distance as depicted in FIGS. 46 to 48. In other words, the groove portion 21 is similar to that in FIG. 3 in the first embodiment.

The groove portions 21D formed in the back surface 20b of the cover glass 20 are provided outside the light receiving area 17 of the image sensor 11 at the application position of the dam material 30, match the external shape of the image sensor 11 in a plan view, and are provided parallel to each other at a predetermined distance, as depicted in FIGS. 46 to 48.

The positional relation between the groove portion 21, the groove portion 21D, and the light receiving area 17 will be described in further detail with reference to FIG. 49. FIG. 49 is a cross-sectional view illustrating the structure of the groove portion 21D of the fifth embodiment and a groove portion 21E of a sixth embodiment described below. In the sixth embodiment, no groove portions 21 are provided, and thus FIG. 49 depicts the groove portion 21 with an alternate long and two short dashes line.

As depicted in FIG. 49, the groove portion 21D is disposed outside the image sensor 11 further from the image sensor 11 than the groove portion 21 by a distance d1. That is, the groove portions 21D are formed at the distance d1 from the outer periphery of the groove portion 21 like a rectangle surrounding the image sensor 11.

Additionally, the groove portion 21D has a width larger than the width over which the dam material 30 is applied, the width enabling the dam material 30 to be inserted into the groove portion 21D. Consequently, when a tip of the dam material 30 is inserted into the groove portion 21D, the dam material 30 is pressed out in the horizontal direction at a bottom portion (ceiling surface) of the groove portion 21D, and is fitted in the groove portion 21D. The dam material 30 is shaped generally like an umbrella as depicted in FIG. 49.

As a result, a peripheral end surface of the groove portion 21D and an end surface of the dam material 30 form an eave 21Ea having a distance d2.

In the bonding between the groove portion 21D and the dam material 30, the tip of the dam material 30 is inserted into the groove portion 21D, and the dam material 30 is pressed out at the bottom portion (ceiling surface) of the groove portion 21D and is fitted in the groove portion 21D, and is bonded to the groove portion 21D all over an inner circumferential surface of the groove portion 21D. Furthermore, compared to simple bonding to the back surface 20b of the cover glass 20, this bonding involves a large bonding area, firmly bonding and fixing the cover glass 20.

Here, two fixation methods will be described below in detail in which the groove portions 21D are provided to allow the cover glass 20 to be bonded and fixed onto the organic substrate 10 via the dam material 30.

FIGS. 50 to 53 illustrate an example of a first method in which the dam material 30 is applied to the image sensor 11 side and in which the cover glass 20 is bonded to the dam material 30 in such a manner as to be overlaid on the dam material 30 from above.

First, as depicted in FIG. 50, the image sensor 11 is bonded onto the organic substrate 10, and connection between the electrode pad 13 and the lead terminal 15 is completed by the bonding wire 14. Understandably, in actuality, the image sensors 11 are regularly arranged on and bonded to the organic substrate sheet 10A, as depicted in FIG. 6. However, here, for easy-to-understand description, an example will be described in which the cover glass 20 is bonded and fixed onto one organic substrate 10.

Then, as depicted in FIG. 51, the dam material 30 is applied onto the electrode pad 13 to which the bonding wire 14 is bonded. The dam material 30 is applied to the cover glass 20 along the external shape of and all along the periphery of the cover glass 20 in the shape of a rectangular frame in plan view. The dam material 30 is shaped like a wall.

Then, as depicted in FIG. 52, the cover glass 20 is overlaid on the image sensor 11 from above.

Then, as depicted in FIG. 53, the cover glass 20 is lowered straight and overlaid on the applied dam material 30 from above. A tip of the applied dam material 30 is provided with a generally semicircular, protruding cross section as depicted in FIG. 51. Thus, when the cover glass 20 is overlaid on the dam material 30, as depicted in FIG. 49, the generally semicircular tip of the dam material 30 is inserted into the groove portion 21D in the cover glass 20 in the direction arrow K1. Then, upon coming into contact with the bottom portion (ceiling surface) of the groove portion 21D, the dam material 30 is pressed out along the bottom surface in the horizontal direction (direction of arrow K2), and is fitted into the groove portion 21D.

As a result, even in a case where the application position of the dam material 30 is slightly misaligned with the center of the groove portion 21D, the tip of the dam material 30 is inserted into the groove portion 21D, and the dam material 30 is pressed out along the bottom portion (ceiling surface) of the groove portion 21D in the horizontal direction (direction of arrow K2). Thus, the dam material 30 is pressed out into an empty space in the groove portion 21D and fitted in the groove portion 21D in such a manner that the groove portion 21D is internally filled with the dam material 30. Consequently, the misalignment of the application position of the dam material 30 is modified. Furthermore, even in a case where a slight amount of the dam material 30 sticks out, the dam material 30 is pushed downward (direction of arrow K3) because the peripheral side surface of the groove portion 21D is formed in the vertical direction. Thus, the dam material 30 is not spread sticking out in the horizontal plane direction of the back surface 20b of the cover glass 20, and is housed inside the groove portion 21D. This configuration provides the dam material 30 itself with a certain height. This enables the height of the cover glass 20 to be reduced.

Now, an example of a second method will be described in which the cover glass 20 is bonded and fixed onto one organic substrate 10 as described above. FIGS. 54 to 56 illustrate a method in which the dam material 30 is applied to the cover glass 20 side and is overlaid on the image sensor 11 from above and bonded to the image sensor 11.

A left figure of FIG. 54, similarly to FIG. 50, depicts a state in which the connection between the electrode pad 13 and the lead terminal 15 is completed by the bonding wire 14. Additionally, a right figure of FIG. 54 depicts a state in which the dam material 30 is applied into the groove portion 21D of the cover glass 20.

In this state, the cover glass 20 is inverted.

Then, as depicted in FIG. 55, the cover glass 20 is placed over the image sensor 11 in such a manner as to be overlaid on the image sensor 11 from above.

Then, as depicted in FIG. 56, the cover glass 20 is lowered straight, and the dam material 30 applied into the groove portion 21D is overlaid on the electrode pad 13 from above. The tip of the applied dam material 30 is provided with a generally semicircular cross section protruding downward as depicted in FIG. 55. Then, when coming into contact with the bonding wire 14 and the electrode pad 13, the tip is pressed out in the horizontal direction. As a result, as described with reference to FIG. 53, the dam material 30 can be applied to the entire surface of the electrode pad 13.

Additionally, even in a case where a slight amount of the dam material 30 sticks out, this amount of the dam material 30 pushed out by sticking-out is pressed out along the bottom portion (ceiling surface) in the groove portion 21D in the horizontal direction (direction of arrow K2), while being applied along the electrode pad 13. Thus, the dam material 30 is not spread sticking out in the horizontal plane direction of the back surface 20b of the cover glass 20 located above the electrode pad 13.

Additionally, there is a predetermined distance between the electrode pad 13 and the light receiving area 17 of the image sensor 11, thus preventing the dam material 30 from sticking out into the light receiving area 17.

Furthermore, the effects of the groove portion 21D will be described in further detail with reference to a figure in FIG. 57 illustrating a comparative example. The cover glass 20 depicted in FIG. 57 includes no groove portions 21D. FIG. 57 corresponds to the state in FIG. 53 where, in the state depicted in FIG. 51, the cover glass 20 with no groove portions 21D is overlaid on the dam material 30 from above and bonded to the dam material 30.

The tip of the dam material 30 applied to the electrode pad 13 is provided with a generally semicircular cross section shape as depicted in FIG. 51. Thus, when the back surface 20b of the cover glass 20 comes into contact with the tip of the dam material 30, shaped generally like a semicircle, the dam material 30 is pushed downward under a downward force. However, the electrode pad 13 is present below, and thus the dam material 30 itself is pressed out in the horizontal direction in order to maintain the volume of the dam material 30. As a result, for example, in an area where a large amount of the dam material 30 is applied, the dam material 30 is pushed out and sicks out in the horizontal direction of the back surface 20b. Then, the sticking-out dam material 30 may enter the light receiving area portion 23 and block light incident on the light receiving area 17. Additionally, the light beam L5 may impinge on and be reflected by the sticking-out dam material 30 and radiated to the light receiving area 17.

As described above, provision of the groove portions 21D allows the dam material 30 to be prevented from being pressed out over the back surface 20b of the cover glass 20 and entering the light receiving area portion 23.

Additionally, the bonding area between the cover glass 20 and the dam material 30 can be increased, and thus the cover glass 20 can be firmly bonded and fixed to the organic substrate 10 via the dam material 30 in close contact with the organic substrate 10. Thus, for example, in a case where the solid-state imaging apparatus 1D is passed through a reflow furnace in the soldering step, defects such as release of the cover glass 20 can be reduced even though the solid-state imaging apparatus 1D is temporarily subjected to a high temperature of 260°C to raise the internal pressure of the cavity 5.

Additionally, the dam material 30 is fitted into the groove portion 21D when being bonded to the groove portion 21D, and thus the bonding position of the cover glass 20 is less likely to be misaligned, and the cover glass 20 can be bonded and fixed to a predetermined position.

In addition, an extra portion of the dam material 30 is prevented from sticking out onto the light receiving area portion 23 to block light incident on the light receiving area 17.

Additionally, as depicted in FIG. 49, the groove portion 21D is disposed further on the outer side than the groove portion 21 provided in the front surface 20a of the cover glass 20. Furthermore, the groove portion 21D is disposed at the distance d1 from the groove portion 21, the light beam L5 is prevented from impinging on and being reflected by the dam material 30 and radiated to the light receiving area 17.

Note that, in the above description, the bottom portion (ceiling surface) of the groove portion 21D described with reference to FIG. 49 is shaped extending generally in the horizontal direction, but is not limited to the shape extending in the horizontal direction. For example, the bottom portion may be provided with any cross-sectional shape such as a general semicircle, a general semi-oval, a general semi-ellipse, a general parabolic, a general inverted catenary, a general inverted trapezoid, or a general inverted triangle in cross-sectional view. Provision with such a cross-sectional shape allows adjustment of the flow of the dam material 30 and the amount of dam material 30 used during bonding.

<8. Configuration Example of Solid-state Imaging Apparatus according to Sixth Embodiment>

Now, a configuration example of a solid-state imaging apparatus 1E according to a sixth embodiment of the present disclosure will be described. The solid-state imaging apparatus 1E according to the sixth embodiment and the solid-state imaging apparatus 1D according to the fifth embodiment are common in that both solid-state imaging apparatuses are provided with the groove portion 21E corresponding to the groove portion 21D in the back surface 20b of the cover glass 20. However, the solid-state imaging apparatus 1E according to the sixth embodiment differs from the solid-state imaging apparatus 1D according to the fifth embodiment in that, in the sixth embodiment, the front surface 20a of the cover glass 20 is provided with no groove portions 21.

That is, in the sixth embodiment, as depicted in the plan view and the side view of the cover glass 20 in FIG. 57, the groove portion 21E is formed surrounding the outer periphery of the light receiving area portion 23 of the image sensor 11 on the back surface 20b of the cover glass 20. However, the front surface 20a of the cover glass 20 is provided with no groove portions 21.

Here, FIG. 58 is a plan view of the solid-state imaging apparatus 1E according to the sixth embodiment. Additionally, FIG. 59 is a cross-sectional view taken along line E-E in FIG. 58. As depicted in FIGS. 58 and 59, the back surface 20b of the cover glass 20 is provided with the groove portion 21E as described above. As is the case with the fifth embodiment, the groove portion 21E has a width larger than the application width of the dam material 30 by the distance d2 between the end surfaces as depicted in FIG. 49. In such formation, when the cover glass 20 is overlaid on the applied dam material 30, the tip of the dam material 30 is inserted in the direction of arrow K1 and comes into contact with the bottom portion (ceiling surface) of the groove portion 21E, and the dam material 30 is pressed out in the horizontal direction (direction of arrow K2) and then in the direction of arrow K3. Accordingly, the groove portion 21E is internally filled with the dam material 30, which forms a general umbrella shape in cross-sectional view. This configuration enables the height of the cover glass 20 to be reduced.

As described above, in the present embodiment, the groove portion 21E formed in the back surface 20b of the cover glass 20 in FIG. 59 and corresponding to the groove portion 21D has effects similar to those in the example in the fifth embodiment. Furthermore, the unique effects of the present embodiment will be described below.

The groove portion 21E of the present embodiment is obtained by forming a rough surface 21Eb on an inner peripheral surface. By providing the rough surface 21Eb, the light beam L5 transmitted through the cover glass 20 impinges on and is diffusely reflected by the rough surface 21Eb formed on the bottom portion (ceiling surface) and the peripheral side surface of the groove portion 21E. Additionally, as described above, the dam material 30 is fitted into the groove portion 21E. Furthermore, the groove portion 21E has a width larger than the application width of the dam material 30 by the distance d2 between the end surfaces, and thus the dam material 30 is shaped generally like an umbrella in cross-sectional view with an eave 21Ea protruding. Thus, the light beam L5 is diffusely reflected by the rough surface 21Eb formed on the inner peripheral surface of the groove portion 21E shaped like an umbrella. Additionally, the light beam L5 is blocked by the eave 21Ea of the groove portion 21 and does not impinge directly on the dam material 30. Consequently, the light beam L5 is prevented from impinging on the dam material 30 and being reflected by the dam material 30, and no reflected light is radiated to the light receiving area 17. Thus, the light blocking effect can be produced.

The rough surface 21Eb has an arithmetic average roughness Ra of, for example, from 0.2 $\mu$m to 50 $\mu$m, preferably from 0.2 $\mu$m to 5 $\mu$m. However, in implementation, another value may be used, and the optimum value only needs to be adopted. In short, it is sufficient if the rough surface 21Eb provided all over the inner peripheral surface of the groove portion 21E causes diffuse reflection, thus producing a light blocking effect.

Additionally, provision of the rough surface 21Eb increases the bonding force generated between the dam material 30 and the rough surface 21Eb. Consequently, potential defects can be suppressed such as release of the dam material 30 from the cover glass 20 due to thermal stress caused by reflow solder or secular changes, and the like.

Additionally, the center of the groove portion 21E may be aligned with the center of the application position of the dam material 30, but may be misaligned with the center of the application position of the dam material 30 in the direction of the light receiving area 17 of the image sensor 11. However, the distance d1 should be secured. Such formation provides the eave 21Ea protruding, allowing the distance d2 to be further increased. This further enhances the light blocking effect.

Additionally, in another embodiment of the groove portion 21E of the present embodiment, a black light blocking film 35 may be formed on the inner peripheral surface. By providing the black light blocking film 35 in the groove portion 21E, the light beam L5 transmitted through the cover glass 20 is blocked by the light blocking film 35 formed on the inner peripheral surface of the groove portion 21E. Thus, the light beam L5 is prevented from impinging directly on the dam material 30 and being reflected by the dam material 30, and no reflected light is radiated to the light receiving area 17. Thus, the light blocking effect can be enhanced.

As described above, according to the present embodiment, effects can be produced that are similar to those described in the fifth embodiment, and the light blocking effect can be exerted with no groove portions 21 provided on the front surface 20a of the cover glass 20. Thus, man-hours can be reduced, allowing costs to be decreased.

<9. Method for Manufacturing Solid-state Imaging Apparatus according to Fifth Embodiment and Sixth Embodiment>

[Method for Manufacturing Solid-state Imaging Apparatus according to Fifth Embodiment]

Now, a method for manufacturing the solid-state imaging apparatus 1D according to the fifth embodiment will be described on the basis of the drawings. FIG. 61A is a front view in an explanatory diagram of the step of processing the cover glass 20 in the method for manufacturing the solid-state imaging apparatus 1D. Additionally, FIG. 61B is a plan view in the explanatory diagram. Note that, for easy-to-understand description, an example in which one piece of the cover glass 20 is processed will be described with reference to FIG. 61.

As depicted in FIG. 61, in the back surface 20b of the cover glass 20, the blade 75 of the dicer is used to engrave the grooves 29D along the disposition positions of the electrode pads 13 where the dam material 30 is applied, in the vertical direction and the horizontal direction. Once engraving in the back surface 20b ends, the cover glass 20 is turned upside down, and the blade 75 of the dicer is used to engrave the grooves 29 along the outer periphery of the light receiving area portion 23 of the front surface 20a in the vertical direction and the horizontal direction.

Note that FIG. 61 illustrates an example of a method for processing a single piece of the cover glass 20. However, in actuality, as depicted in FIGS. 4 and 5, the groove portions 21 and the like are processed in multiple pieces of the cover glass 20 in the glass panel 20A, which is subsequently divided.

In the method for manufacturing the solid-state imaging apparatus 1D, first, a step is executed in which the cover glass 20 is prepared as a member covering the front surface 11a side of the image sensor 11.

In the step of preparing the cover glass 20, the rectangular cover glass 20 with predetermined dimensions is processed as described in the first embodiment.

Specifically, in the back surface 20b of the cover glass 20, the grooves 29D forming the groove portions 21D are engraved along the respective sides of the cover glass 20. The grooves 29D are engraved in the back surface 20b of the cover glass 20 using the apparatus referred to as the dicer as depicted in FIG. 61, as described in the first embodiment with reference to FIGS. 4A and 5A.

Then, the cover glass 20 is turned upside down, and the grooves 209 forming the groove portions 21 in the cover glass 20 are engraved along the sides of the cover glass 20. The grooves 29 are similarly engraved in the front surface 20a of the cover glass 20 using the apparatus referred to as the dicer.

Note that the grooves 29 and the grooves 29D may be engraved in any order, but the order that involves a lower likelihood of scratching the front surface 20a side is preferably used.

The groove 29D is further engraved on the outer side than the groove 29 by the distance d1. Additionally, the width between the groove 29 and the groove 29D is adjusted by adjusting the width of the blade 75 of the dicer.

Note that it is sufficient if, for the processing of the groove 29 in the cover glass 20A, the groove 29 only needs to be formed in an area portion corresponding to the cover glass 20 obtained by division, and the groove 29 need not necessarily be formed to reach the end of the glass panel 20A. Rather, in the present embodiment, the groove not reaching the end is preferable due to the capability of maintaining the mechanical strength.

As described with reference to FIG. 61, after the grooves 29 are engraved in the glass panel 20A in the horizontal direction and the vertical direction, the step of dividing the glass panel 20A is executed. The step of division is similar to that described in the first embodiment, and the description of the step is omitted.

Thus, multiple pieces of the cover glass 20 each shaped like a rectangular plate as depicted in FIG. 46 can be obtained.

Note that engravement of the grooves 29 and the grooves 29D is not limited to the processing with the dicer and may be performed by etching or by laser machining.

The subsequent part of the method for manufacturing the solid-state imaging apparatus 1D according to the fifth embodiment is similar to that in the first embodiment, and the description of the part is omitted.

[Method for Manufacturing Solid-state Imaging Apparatus according to Sixth Embodiment]

Now, a method for manufacturing the solid-state imaging apparatus 1E according to the sixth embodiment will be described. FIG. 62A is a front view in an explanatory diagram of the step of processing the cover glass 20 in the method for manufacturing the solid-state imaging apparatus 1E. Additionally, FIG. 62B is a plan view in the explanatory diagram. Note that, for easy-to-understand description, an example in which one piece of the cover glass 20 is processed will be described with reference to FIG. 62.

In the step of preparing the cover glass 20 in the method for manufacturing the solid-state imaging apparatus 1E according to the sixth embodiment, in the processing of the glass panel 20A, it is unnecessary to engrave the grooves 29 in the front surface 20a of the cover glass 20 constituting the glass panel 20A. That is, the grooves 29D only need to be exclusively engraved in the back surface 20b of the cover glass 20.

Then, the rough surface 21Eb is formed on the inner peripheral surface of the groove portion 21E. The rough surface 21Eb can be formed by sandblasting. Additionally, by appropriately selecting the roughness (count) of the blade 75 of the dicer to engrave the grooves 29E, when the groove 29E is engraved, the rough surface 21Eb can be simultaneously formed.

Additionally, instead of forming the rough surface 21Eb, the light blocking film 35 may be formed by using an inkjet system to apply a black resin to the inner peripheral surface of the groove 29E.

Otherwise, the method for manufacturing the solid-state imaging apparatus 1E according to the sixth embodiment is similar to the method for manufacturing the solid-state imaging apparatus 1D according to the fifth embodiment, and the further description is omitted.

<10. Configuration Example of Electronic Equipment>

FIG. 63 is used to describe an application example in which the solid-state imaging apparatus 1 according to the embodiments described above is applied to electronic equipment. Note that the application example is common to the solid-state imaging apparatuses according to the first to sixth embodiments.

The solid-state imaging apparatus 1 is applicable to electronic equipment in general using an image capturing section (photoelectric conversion section), such as an imaging apparatus such as a digital still camera or a video camera, a portable terminal apparatus having an imaging function, or a copier using a solid-state imaging element in an image reading section. The solid-state imaging apparatus 1 may be formed as one chip, or may be in a modular form having an imaging function in which an imaging section and a signal processing section or an optical system are packaged together.

As depicted in FIG. 63, an imaging apparatus 200 as electronic equipment includes an optical section 202, the solid-state imaging apparatus 1, a DSP (Digital Signal Processor) circuit 203 that is a camera signal processing circuit, a frame memory 204, a display section 205, a recording section 206, an operation section 207, and a power supply section 208. A bus line including a signal line and a feeding line is used to connect the DSP circuit 203, the frame memory 204, the display section 205, the recording section 206, the operation section 207, and the power supply section 208 to each other.

The optical section 202 includes multiple lenses, and captures incident light (image light) from a subject to form an image on an imaging surface of the solid-state imaging apparatus 1. The solid-state imaging apparatus 1 converts, into an electric signal in pixel units, the quantity of incident light formed into an image on the imaging surface by the optical section 202, to output the electric signal as a pixel signal.

The display section 205 includes, for example, a panel display apparatus such as a liquid crystal panel or an organic EL (Electro Luminescence) panel to display a moving image or a still image captured by the solid-state imaging apparatus 1. The recording section 206 records, in a recording medium such as a hard disk or a semiconductor memory, the moving image or the still image captured by the solid-state imaging apparatus 1.

The operation section 207 issues operation commands for various functions of the imaging apparatus 200 under the operation of a user. The power supply section 208 appropriately provides various power supplies corresponding to operation power supplies for the DSP circuit 203, the frame memory 204, the display section 205, the recording section 206, and the operation section 207, to these supply targets.

According to the imaging apparatus 200 described above, potential resin burrs in the solid-state imaging apparatus 1 can be suppressed, and potential flare is prevented. Thus, high-quality captured images can be obtained.

The description of the above-described embodiments is an example of the present technology, and the present technology is not limited to the above-described embodiments. Thus, needless to say, embodiments other than those described above are possible, and various changes can be made to the embodiments in accordance with the design or the like without departing from the technical concepts according to the present disclosure. Additionally, the effects described herein are only illustrative and not restrictive, and other effects may be produced. In addition, the configurations of the embodiments and the configurations of variations described above can be appropriately combined.

Note that the present technology can be configured as follows.

(1) A solid-state imaging apparatus including:

a substrate;
an image sensor provided on the substrate;
a transparent member provided on the image sensor via a support portion; and
a mold resin portion formed around the image sensor and the transparent member on the substrate, in which

a front surface side of the transparent member is provided with a groove portion in a region outside a light receiving area of the image sensor.

(2) A solid-state imaging apparatus including:

a substrate;
an image sensor provided on the substrate;
a transparent member provided on the image sensor via a support portion; and
a mold resin portion formed around the image sensor and the transparent member on the substrate, in which
a side surface of the transparent member is provided with a groove portion in a region outside a light receiving area of the image sensor.

(3) A solid-state imaging apparatus including:

a substrate;
an image sensor provided on the substrate;
a transparent member provided on the image sensor via a support portion; and
a mold resin portion formed around the image sensor and the transparent member on the substrate, in which
a back surface of the transparent member is provided with a groove portion in a region outside a light receiving area of the image sensor.

(4) The solid-state imaging apparatus according to (1) or (2) described above, in which

the mold resin portion includes a material having a light blocking effect, and
the groove portion is internally filled with a material forming the mold resin portion.

(5) The solid-state imaging apparatus according to any one of (1) to (4) described above, in which

the transparent member is a member shaped like a rectangular plate, and
the groove portion is formed along four sides of the transparent member.

(6) The solid-state imaging apparatus according to (1), (4), or (5) described above, in which
the transparent member includes a plurality of the groove portions along at least one of four sides of the transparent member.
(7) The solid-state imaging apparatus according to any one of (1) to (6) described above, in which
the groove portion is shaped like a rectangle surrounding an outer periphery of the light receiving area.
(8) The solid-state imaging apparatus according to any one of (1) to (7) described above, in which
a light blocking film is formed on an inner surface of the groove portion.
(9) The solid-state imaging apparatus according to (2) described above, in which
a corner portion between a front surface and the side surface of the transparent member has an acute angle.
(10) The solid-state imaging apparatus according to (3) described above, in which,
in a front surface and the back surface of the transparent member, the groove portion is formed in a region outside the light receiving area of the image sensor.
(11) The solid-state imaging apparatus according to (3) or (10) described above, in which
the groove portion formed in the back surface of the transparent member is formed in such a manner that the support portion of the transparent member is fitted into the groove portion.
(12) The solid-state imaging apparatus according to (3), (10), or (11) described above, in which
the groove portion formed in the back surface of the transparent member is provided with a width larger than that of the support portion of the transparent member.
(13) The solid-state imaging apparatus according to (3) or any one of (10) to (12) described above, in which
the groove portion formed in the back surface of the transparent member is provided with a rough surface on an inner peripheral surface of the groove portion.
(14) A solid-state imaging apparatus including:

a transparent member shaped like a rectangular plate; and
a groove portion that is formed in a front surface of the transparent member along four sides of the rectangular plate and that has a V shape or an inverted trapezoidal shape having an angle $\theta 3$ between an oblique side and a perpendicular, the angle being larger than half of a maximum refracting angle $\theta c1$.

(15) The solid-state imaging apparatus according to (14) described above, in which
the groove portion is shaped like a rectangle surrounding an outer periphery of a light receiving area of an image sensor.

(16) The solid-state imaging apparatus according to (14) or (15) described above, in which
the groove portion is internally provided with a light blocking film or filled with a material having a light blocking effect.

(17) A method for manufacturing a solid-state imaging apparatus, the method including the steps of:

preparing, as a member covering a front surface side of an image sensor, a transparent member including a groove portion with at least one side opening to a side surface of the transparent member, in a region outside an area portion corresponding to a light receiving area of the image sensor on the front surface side;
mounting multiple image sensors on a substrate sheet to produce a package substrate sheet with the transparent member provided on each of the image sensors via a support portion;
performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side and injecting a resin material into the molding space to form a mold resin portion around the image sensor and the transparent member on the substrate sheet; and
dividing a plate-like structure with the mold resin portion formed on the package substrate sheet into multiple chips corresponding to the image sensors.

(18) A method for manufacturing a solid-state imaging apparatus, the method including the steps of:

preparing, as a member covering a front surface side of an image sensor, a transparent member including a groove portion opening to a side surface of the transparent member, in a region outside an area portion corresponding to a light receiving area of the image sensor on the front surface side;
mounting multiple image sensors on a substrate sheet to produce a package substrate sheet with the transparent member provided on each of the image sensors via a support portion;
performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side and injecting a resin material into the molding space to form a mold resin portion around the image sensor and the transparent member on the substrate sheet; and
dividing a plate-like structure with the mold resin portion formed on the package substrate sheet into multiple chips corresponding to the image sensors.

(19) A method for manufacturing a solid-state imaging apparatus, the method including the steps of:

preparing, as a member covering a front surface side of an image sensor, a transparent member including a groove portion formed in such a manner that a support portion is fitted, in a region outside an area portion corresponding to a light receiving area of the image sensor on a back surface side, the support portion being disposed in the region;
mounting multiple image sensors on a substrate sheet to produce a package substrate sheet with the transparent member provided on each of the image sensors via the support portion;
performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side, and injecting a resin material into the molding space to form a mold resin portion around the image sensor and the transparent member on the substrate sheet; and
dividing a plate-like structure with the mold resin portion formed on the package substrate sheet into multiple chips corresponding to the image sensors.

(20) The method for manufacturing a solid-state imaging apparatus according to (17) or (18) described above, in which,
in the step of forming the mold resin portion, a material having a light blocking effect is used as the resin material.

(21) Electronic equipment including:

a solid-state imaging apparatus including

a substrate,
an image sensor provided on the substrate,
a transparent member provided on the image sensor via a support portion, and
a mold resin portion formed around the image sensor and the transparent member on the substrate, in which
a front surface, a side surface, or a back surface of the transparent member is provided with a groove portion
in a region outside a light receiving area of the image sensor.

(22) Electronic equipment including:
a solid-state imaging apparatus including

a transparent member formed like a rectangular plate, and
a groove portion that is formed in a front surface of the transparent member along four sides of the rectangular
plate and that has a V shape or an inverted trapezoidal shape having an angle θ3 between an oblique side and
a perpendicular, the angle being larger than half of a maximum refracting angle θc1.

[Reference Signs List]

1: Solid-state imaging apparatus
10: Organic substrate
10A: Organic substrate sheet
11: Image sensor
12: Bonding layer
13: Electrode pad
14: Bonding wire
15: Lead terminal
16: Pixel
17: Light receiving area
20: Cover glass (transparent member)
20a: Front surface
20b: Back surface
20c: Side surface
20d: Margin portion
20A: Glass panel
21: Groove portion
21a: Inner side surface
21b: Bottom surface
21X: Outer groove portion
21Y: Inner groove portion
21Z: Frame-like groove portion
22: Communication groove portion
23: Light receiving area portion
24: Light blocking film
25: Cutting line
26: Corner portion
27: Corner portion
29: Groove
30: Dam material
35: Light blocking film
40: External connection terminal
50: Package substrate sheet
55: Organic substrate package
60: Mold resin portion
60M: Mold resin material
61: Sheet

62: In-groove resin portion
66: First bulging portion
67: Second bulging portion
70: Mold tool
71: Upper mold (first mold)
72: Lower mold (second mold)
73: Cavity (molding space)
74: Gate
75: Blade
200: Imaging apparatus (electronic equipment)
$\theta11$: Maximum incident angle
$\theta c1$: Maximum refracting angle
$\theta12$: Incident angle of incident light
$\theta c2$: Refracting angle at which incident angle is $\theta12$
$\theta3$: Angle between inner side surface of groove portion and perpendicular
L6, L7: Incident light
d1, d2: Distance

**Claims**

1. A solid-state imaging apparatus comprising:

   a substrate;
   an image sensor provided on the substrate;
   a transparent member provided on the image sensor via a support portion; and
   a mold resin portion formed around the image sensor and the transparent member on the substrate, wherein
   a front surface of the transparent member is provided with a groove portion in a region outside a light receiving area of the image sensor.

2. A solid-state imaging apparatus comprising:

   a substrate;
   an image sensor provided on the substrate;
   a transparent member provided on the image sensor via a support portion; and
   a mold resin portion formed around the image sensor and the transparent member on the substrate, wherein
   a side surface of the transparent member is provided with a groove portion in a region outside a light receiving area of the image sensor.

3. A solid-state imaging apparatus comprising:

   a substrate;
   an image sensor provided on the substrate;
   a transparent member provided on the image sensor via a support portion; and
   a mold resin portion formed around the image sensor and the transparent member on the substrate, wherein
   a back surface of the transparent member is provided with a groove portion in a region outside a light receiving area of the image sensor.

4. The solid-state imaging apparatus according to claim 1, wherein

   the mold resin portion includes a material having a light blocking effect, and
   the groove portion is internally filled with a material forming the mold resin portion.

5. The solid-state imaging apparatus according to claim 1, wherein

   the transparent member is a member shaped like a rectangular plate, and
   the groove portion is formed along four sides of the transparent member.

**6.** The solid-state imaging apparatus according to claim 1, wherein
the transparent member includes a plurality of the groove portions along at least one of four sides of the transparent member.

**7.** The solid-state imaging apparatus according to claim 1, wherein
the groove portion is shaped like a rectangle surrounding an outer periphery of the light receiving area.

**8.** The solid-state imaging apparatus according to claim 1, wherein
a light blocking film is formed on an inner surface of the groove portion.

**9.** The solid-state imaging apparatus according to claim 2, wherein
a corner portion between a front surface and the side surface of the transparent member has an acute angle.

**10.** The solid-state imaging apparatus according to claim 3, wherein,
in a front surface and the back surface of the transparent member, the groove portion is formed in a region outside the light receiving area of the image sensor.

**11.** The solid-state imaging apparatus according to claim 3, wherein
the groove portion formed in the back surface of the transparent member is formed in such a manner that the support portion of the transparent member is fitted into the groove portion.

**12.** The solid-state imaging apparatus according to claim 3, wherein
the groove portion formed in the back surface of the transparent member is provided with a width larger than that of the support portion of the transparent member.

**13.** The solid-state imaging apparatus according to claim 3, wherein
the groove portion formed in the back surface of the transparent member is provided with a rough surface on an inner peripheral surface of the groove portion.

**14.** A solid-state imaging apparatus comprising:

a transparent member shaped like a rectangular plate, and
a groove portion that is formed in a front surface of the transparent member along four sides of the rectangular plate and that has a V shape or an inverted trapezoidal shape having an angle between an oblique side and a perpendicular, the angle being larger than half of a maximum refracting angle.

**15.** The solid-state imaging apparatus according to claim 14, wherein
the groove portion is shaped like a rectangle surrounding an outer periphery of a light receiving area of an image sensor.

**16.** The solid-state imaging apparatus according to claim 14, wherein
the groove portion is internally provided with a light blocking film or filled with a material having a light blocking effect.

**17.** A method for manufacturing a solid-state imaging apparatus, the method comprising the steps of:

preparing, as a member covering a front surface side of an image sensor, a transparent member including a groove portion with at least one side opening to a side surface of the transparent member, in a region outside an area portion corresponding to a light receiving area of the image sensor on the front surface side;
mounting multiple image sensors on a substrate sheet to produce a package substrate sheet with the transparent member provided on each of the image sensors via a support portion;
performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side and injecting a resin material into the molding space to form a mold resin portion around the image sensor and the transparent member on the substrate sheet; and
dividing a plate-like structure with the mold resin portion formed on the package substrate sheet into multiple chips corresponding to the image sensors.

18. A method for manufacturing a solid-state imaging apparatus, the method comprising the steps of:

preparing, as a member covering a front surface side of an image sensor, a transparent member including a groove portion opening to a side surface of the transparent member, in a region outside an area portion corresponding to a light receiving area of the image sensor on the front surface side;

mounting multiple image sensors on a substrate sheet to produce a package substrate sheet with the transparent member provided on each of the image sensors via a support portion;

performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side and injecting a resin material into the molding space to form a mold resin portion around the image sensor and the transparent member on the substrate sheet; and

dividing a plate-like structure with the mold resin portion formed on the package substrate sheet into multiple chips corresponding to the image sensors.

19. A method for manufacturing a solid-state imaging apparatus, the method comprising the steps of:

preparing, as a member covering a front surface side of an image sensor, a transparent member including a groove portion formed in such a manner that a support portion is fitted, in a region outside an area portion corresponding to a light receiving area of the image sensor on a back surface side, the support portion being disposed in the region;

mounting multiple image sensors on a substrate sheet to produce a package substrate sheet with the transparent member provided on each of the image sensors via the support portion;

performing injection molding using a mold tool having a first mold with a molding surface covered with a sheet including an elastic material and a second mold forming a molding space along with the first mold, by setting the package substrate sheet in the mold tool with the transparent member side corresponding to the first mold side and with the substrate sheet side corresponding to the second mold side, and injecting a resin material into the molding space to form a mold resin portion around the image sensor and the transparent member on the substrate sheet; and

dividing a plate-like structure with the mold resin portion formed on the package substrate sheet into multiple chips corresponding to the image sensors.

20. The method for manufacturing a solid-state imaging apparatus according to claim 17, wherein,

in the step of forming the mold resin portion, a material having a light blocking effect is used as the resin material.

21. Electronic equipment comprising:

a solid-state imaging apparatus including

a substrate,
an image sensor provided on the substrate,
a transparent member provided on the image sensor via a support portion, and
a mold resin portion formed around the image sensor and the transparent member on the substrate, wherein

a front surface, a side surface, or a back surface of the transparent member is provided with a groove portion in a region outside a light receiving area of the image sensor.

22. Electronic equipment comprising:
a solid-state imaging apparatus including

a transparent member formed like a rectangular plate, and
a groove portion that is formed in a front surface of the transparent member along four sides of the rectangular plate and that has a V shape or an inverted trapezoidal shape having an angle between an oblique side and a perpendicular, the angle being larger than half of a maximum refracting angle.

# FIG.1

FIG.2

# FIG.3

A

B

# FIG.4

A

B

# F I G . 5

A

B

FIG.6

FIG.7

FIG.8

# FIG.9

FIG.10

# FIG.11

# FIG.12

# FIG.13

# FIG.14

# FIG.15

# FIG.16

# FIG.17

A

21(21X)  20c  20  20d  21(21X)

23

20c

Z ⟹

20d

20a

20d  20d  20c

21(21X)

21(21Y)

20d

20c

21(21Y)

21(21X)

B

20d  21(21X)  21(21Y)  20a  20  21(21Y)  21(21X)  20d

20c  20c

20c  20b

# FIG.18

# FIG.19

<u>A</u>

<u>B</u>

FIG.20

# FIG.21

A

B

C

# FIG.22

# FIG.23

FIG.24

FIG.25

# FIG.26

# FIG.27

FIG.28

FIG.29

FIG.30

# F I G . 3 1

# FIG.32

A

29A(21A)

20c

D4

D4

20

D3

23

17

20c

29B(21B)

D3

20c

20c

↑ Y

B

27

20a

27

20

20c

21a

29B(21B)

29B(21B)

W

21b

21a

21a

D4

21b

20b

D4

21a

21b

29A(21A)

20c

# FIG.33

# FIG.34

A

B

# FIG.35

# FIG.36

A

B

# FIG.37

# FIG.38

# FIG.39

# FIG.40

A

B

FIG.41

FIG.42

FIG.43

FIG.44

FIG.45

# F I G . 4 6

FIG.47

# FIG.48

A

20

21D

21D

21

21

21D

21

21

21D

21

B

21

20a

21

20

21D

21D

20b

FIG.49

FIG.50

# FIG.51

# FIG.52

FIG.53

FIG.54

# FIG.55

# FIG.56

# FIG.57

# FIG.58

FIG.59

# F I G . 6 0

A

20

21E

21E

21

21E

21E

B

20

20a

21E

20b

21E

# FIG.61

A

75

A1

75A

29(21)

20a

29(21)

20

29D(21D)

20b

29D(21D)

B

29(21)

29(21)

29D(21D)

29(21)

29(21)

29D(21D)

29D(21D)

29D(21D)

# FIG.62

A

75

A1

75A

29E(21E)

20b

29E(21E)

20

20a

B

29E(21E)

29E(21E)

29E(21E)

29E(21E)

# FIG.63

## INTERNATIONAL SEARCH REPORT

| | International application No. |
|---|---|
| | **PCT/JP2021/027489** |

| A. | CLASSIFICATION OF SUBJECT MATTER |
|---|---|

*H01L 23/02*(2006.01)i; *H01L 23/28*(2006.01)i; *H01L 23/29*(2006.01)i; *H01L 23/31*(2006.01)i; *H01L 27/146*(2006.01)i; *H04N 5/335*(2011.01)i

FI: H01L27/146 D; H01L23/02 F; H01L23/02 J; H01L23/28 C; H01L23/30 F; H04N5/335

According to International Patent Classification (IPC) or to both national classification and IPC

| B. | FIELDS SEARCHED |
|---|---|

Minimum documentation searched (classification system followed by classification symbols)

H01L23/02; H01L23/28; H01L23/29; H01L23/31; H01L27/146; H04N5/335

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 61-276271 A (NEC KYUSHU LTD.) 06 December 1986 (1986-12-06) | 1, 4-7, 21 |
| | page 1, left column, fig. 1 | |
| A | page 1, left column, fig. 1 | 2-3, 8-20, 22 |
| X | JP 2018-160763 A (OLYMPUS CORP.) 11 October 2018 (2018-10-11) | 2-3, 9, 14-16, 21-22 |
| | paragraphs [0047], [0050], fig. 7 | |
| Y | paragraphs [0022], [0070], fig. 1 | 1, 4-7, 11-12, 21 |
| A | paragraphs [0022], [0047], [0050], [0070], fig. 1, 7 | 8, 10, 13, 17-20 |
| X | JP 2008-16693 A (FUJIFILM CORP.) 24 January 2008 (2008-01-24) | 2, 21 |
| | paragraphs [0007]-[0013], fig. 1 | |
| Y | fig. 4 | 11-12 |
| A | paragraphs [0007]-[0013], fig. 1, 4 | 1, 3-10, 13-20, 22 |

| ☐ Further documents are listed in the continuation of Box C. | ✓ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **13 October 2021** | **26 October 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2021/027489**

| Patent document cited in search report | | | Publication date (day/month/year) | Patent family member(s) | Publication date (day/month/year) |
|---|---|---|---|---|---|
| JP | 61-276271 | A | 06 December 1986 | (Family: none) | |
| JP | 2018-160763 | A | 11 October 2018 | US 2018/0278816 A1 paragraphs [0034], [0060], [0063], [0083], fig. 1, 7 | |
| JP | 2008-16693 | A | 24 January 2008 | (Family: none) | |

Form PCT/ISA/210 (patent family annex) (January 2015)

**REFERENCES CITED IN THE DESCRIPTION**

**Patent documents cited in the description**

• JP 2016004856 A